# EUROPEAN PATENT SPECIFICATION

(11) **EP 4 502 772 B1**
(45) Date of publication and mention of the grant of the patent: **08.07.2026**
(21) Application number: 23306333.8
(22) Date of filing: 03.08.2023
(51) Int. Cl.: G06F 3/0354, G06F 3/0346

(54) **PASSIVE ACCESSORIES**
PASSIVES ZUBEHÖR
ACCESSOIRES PASSIFS

(43) Date of publication of application: 05.02.2025
(73) Proprietor: Advanced Magnetic Interaction, AMI, 38170 Seyssinet-Pariset (FR)
(72) Inventor: Antonakis, Ion-Ioannis, 14569 Anoixi (GR); Hautson, Tristan, 38170 Seyssinet-Pariset (FR); Pellerano, Vincent Thomas, 38170 Seyssinet-Pariset (FR)
(74) Representative: Peterreins Schley

(56) References cited:
- WO-A1-2022/018691
- US-A1- 2022 258 039

## Description

### TECHNICAL FIELD

The present disclosure relates to the technical field of determining and/or tracking a location of passive accessories, more specifically to a user-borne device operable on an interaction surface, to a system for determining a manipulation of a user-borne device, and to a method for determining a manipulation of a user-borne device.

### BACKGROUND

In the technical field of location determination and/or tracking of a device held or worn by user (i.e., a user-borne device), the provision of a plurality of magnetometers allows to measure a magnetic field associated with a magnetic object arranged in or coupled to the user-borne device. The user-borne devices using this technology may be electronically and/or electrically passive. More specifically, electrically passive means that the user-borne device may not comprise a power source (e.g., batteries) and/or means to receive power (e.g., wireless power transmission via an inductive coil) for powering an electronic feature of the user-borne device. Electronically passive means that no computation or processing occurs (or happens) on the user-borne device. The magnetometer measurements enable determining and/or tracking of the location of the magnetic object within a sensing volume created by the plurality of magnetometers. In some applications, the magnetic object may be arranged within a writing device (e.g., a stylus) which may be operated by a user on a writing support during a user operation. Based on the magnetic field measurements associated with the magnetic object, a location of the writing device on the writing support may be determined. The principles of determining the location and/or tracking of a magnetic object with a plurality of magnetometers and the associated algorithms are already known in the prior art, for example in US 2013/249784 A1 or US 2020/116524 A1.

Document US 2022/258039 A1 relates to a method for controlling a graphic interface for displaying images of a digital representation of a launcher in a virtual environment, the launcher comprising a launching arm equipped with a magnet.

The determination and/or tracking of a location of a user-borne device with a plurality of magnetometers may require the definition of an interaction surface on which the user-borne device may be operated or with respect to which the location of the user-borne device may be determined. The user-borne device may be operated directly on the interaction surface, or at a distance to the interaction surface (e.g., in the air). In known devices, manufacturing tolerances, e.g., manufacturing inaccuracies of the arrangement of the plurality of magnetometers may occur and/or the interaction surface may not be always known or defined accurately with respect to the plurality of magnetometers and/or with respect to the user-borne device. In some examples, the plurality of magnetometers may be tilted in an unknown way relative to the interaction surface (and vice versa), e.g., when the user-borne device is operated on a surface (i.e., the interaction surface) that is different from a surface of the device that includes the plurality of magnetometers. In other examples, the interaction surface and its location (i.e., the interaction surface location), including a position and/or an orientation relative to the plurality of magnetometers and/or to the user-borne device, may be changed arbitrarily by a user (e.g., the user-borne device may be operated on a book used as interaction surface, then on a table and so on). In some known applications, the interaction surface location may be somehow assumed or approximated. However, this can lead to inaccurate or unknown interaction surface locations relative to the plurality of magnetometers and/or to the user-borne device, which may affect the user experience due to inaccurate and unreliable tracking and/or location determination of the user-borne device. Furthermore, the applicability of the tracking and/or location determination of the user-borne device may be limited to very specific embodiments and arrangements of a user-borne device relative to a plurality of magnetometers.

Thus, the object of the present disclosure is to provide a user-borne device operable on an interaction surface, a system and a method for determining a manipulation of a user-borne device, which enable a tracking and/or a location determination of a user-borne device manipulated within a sensing volume with increased accuracy and reliability, and more specifically which enable an accurate and reliable determination of the interaction surface.

### SUMMARY

The present disclosure relates to a user-borne device operable on an interaction surface as defined in claim 1, a system for determining a manipulation of a user-borne device as defined in claim 13, and a computer-implemented method for determining a manipulation of a user-borne device as defined in claim 14. Furthermore, the present disclosure relates to a computer program configured to execute the computer-implemented method as defined in claim 15, and a computer-readable medium storing the computer program as defined in claim 16. The dependent claims depict advantageous embodiments of the present disclosure.

According to a first aspect of the present disclosure, a user-borne device operable on an interaction surface comprises a housing, a magnetic object coupled to the housing, and at least one contact manipulation feature movably coupled to the housing. The at least one contact manipulation feature is configured to interact with the magnetic object such that an actuation of the at least one contact manipulation feature causes a transition of the magnetic object from a first state to a second state. The first state is indicative of the user-borne device being distanced to the interaction surface, and the second state is indicative of the user-borne device being in contact with the interaction surface. The transition from the first state to the second state is indicative of a contact event of the user-borne device with the interaction surface. The transition may be detected by a plurality of magnetometers and may be associated with a contact event of the user-borne device with the interaction surface. "Transition" means that the magnetic object provides a change from the first state to the second state that is detectable with the plurality of magnetometers. Thus, the interaction surface, more specifically the interaction surface location, may be defined in an accurate and/or reliable way. More specifically, based on an actuation of the at least one contact manipulation feature, the transition from the first state to the second state may be detected and the contact event may be determined which in turn may be applied to precisely derive the interaction surface location. This may lead to an improved determination of a location and/or tracking of the user-borne device relative to the interaction surface and/or the plurality of magnetometers, more specifically with increased accuracy and reliability. This may be the case even when the interaction surface and its location are initially unknown, and/or when the user operates the user-borne device on different interaction surfaces or in the air (i.e., without physical contact with the interaction surface). Furthermore, electronic components in the user-borne device to actively provide data to determine the location of the interaction surface (e.g., electronic sensors) can be avoided. Thus, the user-borne device can be provided electronically and/or electrically passive. This may lead to lower costs and to a lower complexity of the user-borne device. Furthermore, additional functions can be integrated in the user-borne device and application fields of the user-borne device can be extended. At least one trigger event which will be described in detail below (e.g., associated with the additional functions) may be controlled by the user-borne device in an improved manner, as it may be coupled with the detectable transition of the magnetic object. The contact event and/or the at least one trigger event may be initiated by a user manipulation of the user-borne device within a sensing volume. The contact event may be initiated by a contact of the user-borne device, more specifically of the at least one contact manipulation feature, with the interaction surface and within the sensing volume. The contact event and/or the at least one trigger event may cause an action and/or may be used to control an action in a digital environment (i.e., an environment which is controlled by a computer or a network of computers), more specifically a virtual environment. The contact event may implement a user input or a physical contact of the at least one contact manipulation feature with the interaction surface, which may be used for a precise definition of the interaction surface (location). It should be noted that in the present disclosure, the magnetic object should be interpreted as at least one magnetic object and the contact event should be interpreted as at least one contact event.

According to a second aspect of the present disclosure, a system for determining a manipulation of a user-borne device comprises a user-borne device according to the first aspect of present disclosure, and a plurality of magnetometers. The plurality of magnetometers is configured to create a sensing volume and configured to measure a magnetic field created by the magnetic object. The system is configured to detect a transition of the magnetic object from a first state to a second state. The system is configured to determine a contact event of the user-borne device with the interaction surface based on the detected transition. The above-described effects and advantages may apply analogously to the system. The transition may be indicative of the contact event, which may be detected and determined by the system. The system may use the determined contact event to derive a definition of the interaction surface location with increased accuracy and reliability. Thus, the system may determine a location and/or tracking of the user-borne device relative to the interaction surface with increased accuracy and reliablity. Such a system may allow the tracking and/or location determination of a user-borne device, more specifically an electronically and/or electrically user-borne device, in at least five degrees of freedom with a magnetic object.

According to a third aspect of the present disclosure, a method for determining a manipulation of a user-borne device comprises obtaining magnetic field measurements associated with a magnetic field created by a magnetic object coupled to a housing of a user-borne device according to the first aspect of the present disclosure and measured with a plurality of magnetometers. The method further comprises detecting a transition of the magnetic object from a first state to a second state. The method further comprises determining a contact event of the user-borne device with the interaction surface based on the detected transition. The above-described effects and advantages for the system and the user-borne device may apply analogously to the method. The method for determining a manipulation of a user-borne device may be a computer-implemented method. Further aspects of the present disclosure relate to a computer system configured to execute the computer-implemented method, a computer program configured to execute the computer-implemented method and/or a computer-readable medium or signal storing the computer program.

### BRIEF DESCRIPTION OF THE DRAWINGS

Other characteristics will be apparent from the accompanying drawings, which form a part of this disclosure. The drawings are intended to further explain the present disclosure and to enable a person skilled in the art to practice it. However, the drawings are intended as non-limiting examples. Common reference numerals on different figures indicate like or similar features.
- **Fig. 1**: is a schematic view of a user-borne device and a system for determining a manipulation of a user-borne device according to aspects of the present disclosure;
- **Figs. 2A and 2B**: are schematic views of a first embodiment of the user-borne device;
- **Figs. 3A and 3B**: are schematic views of a second embodiment of the user-borne device;
- **Figs. 4A and 4B**: are schematic views of a third embodiment of the user-borne device;
- **Figs. 5A and 5B**: are schematic views of a fourth embodiment of the user-borne device;
- **Figs. 6A and 6B**: are schematic views of a sixth embodiment of the user-borne device;
- **Figs. 7A and 7B**: are schematic views of a seventh embodiment of the user-borne device;
- **Figs. 7C and 7D**: are schematic views of an eighth embodiment of the user-borne device;
- **Figs. 8A and 8B**: are schematic views of a ninth embodiment of the user-borne device;
- **Figs. 9A and 9B**: are schematic views of a tenth embodiment of the user-borne device, wherein the user-borne device may be a writing device;
- **Figs. 10A and 10B**: are a top view and a schematic front view of the user-borne device according to aspects of the present disclosure;
- **Figs. 11A to 13B**: are schematic views of the user-borne device according to aspects of the present disclosure comprising at least one magnetic object that is rotatable and/or translatable relative to the housing;
- **Fig. 14**: is a schematic view of an arrangement of a plurality of magnetometers relative to an interaction support;
- **Fig. 15**: is a schematic view of a user-borne device according to the aspects of the present disclosure, wherein the user-borne device is translated on an interaction surface;
- **Fig. 16**: is a schematic view of a process flow diagram of a method for determining a manipulation of a user-borne device according to aspects of the present disclosure;

### DETAILED DESCRIPTION

Embodiments of the user-borne device operable on an interaction surface, the system and the method for determining a manipulation of a user-borne device by a user according to the present disclosure will be described in reference to the drawings as follows.

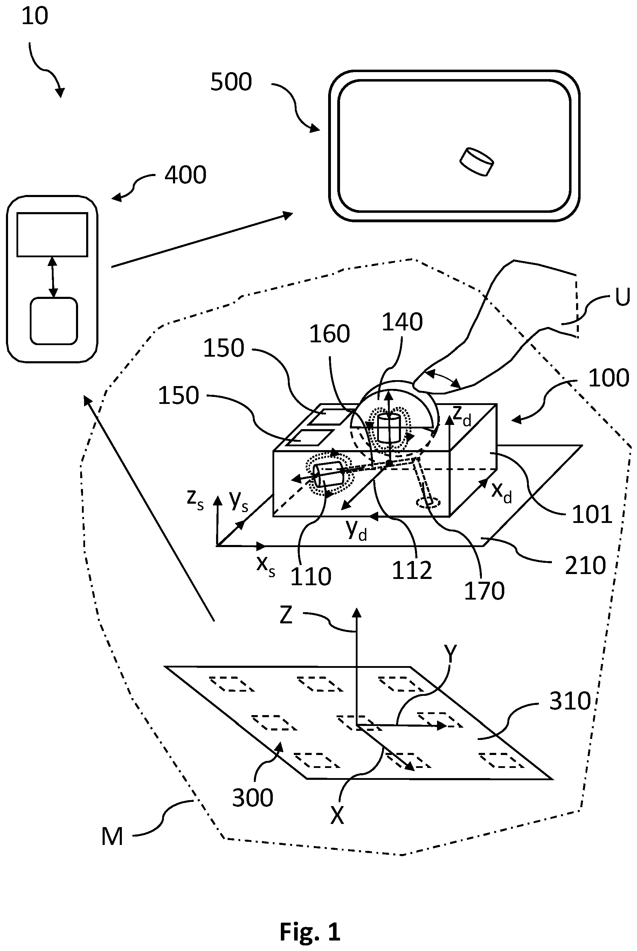

Fig. 1 schematically illustrates a system 10 for determining a manipulation of a user-borne device 100. The system 10 comprises a user-borne device 100 operable on an interaction surface 210 according to a first aspect of the present disclosure. The user-borne device 100 comprises a housing 101, a magnetic object 110 coupled to the housing 101, and at least one contact manipulation feature 170 movably coupled to the housing 101. The at least one contact manipulation feature 170 is configured to interact with the magnetic object 110 such that an actuation of the at least one contact manipulation feature 170 causes a transition of the magnetic object 110 from a first state to a second state. The transition from the first state to the second state is indicative of a contact event of the user-borne device 100 with the interaction surface 210. The determination (and/or tracking) of a location of a user-borne device 100 with a plurality of magnetometers 300 requires the definition of an interaction surface 210 on which the user-borne device 100 may be operated or with respect to which the location of the user-borne device may be determined. The transition may be detected by the plurality of magnetometers 300 and may be linked with a contact event of the user-borne device 100 with the interaction surface 210. "Transition" means that the magnetic object 110 provides a change from the first state to the second state that is detectable with the plurality of magnetometers. Thus, the interaction surface 210, more specifically the interaction surface location, may be defined in an accurate and/or reliable way. More specifically, based on an actuation of the at least one contact manipulation feature 170, the transition from the first state to the second state may be detected and the contact event may be determined which in turn may be applied to precisely derive the interaction surface location. This may lead to an improved determination of a location and/or tracking of the user-borne device 100 relative to the interaction surface 210 and/or the plurality of magnetometers 300, more specifically with increased accuracy and reliability. This may be the case even when the interaction surface 210 and its location are initially unknown, and/or when the user operates the user-borne device 100 on different interaction surfaces or in the air (i.e., without physical contact with the interaction surface). Furthermore, electronic components in the user-borne device 100 to actively provide data to determine the location of the interaction surface 210 (e.g., electronic sensors) can be avoided. Thus, the user-borne device 100 can be provided electronically and/or electrically passive. This may lead to lower costs and to a lower complexity of the user-borne device. Furthermore, additional functions can be integrated in the user-borne device 100 and application fields of the user-borne device 100 can be extended. At least one trigger event which will be described in detail below (e.g., associated with the additional functions) may be controlled by the user-borne device 100 in an improved manner, as it may be coupled with the detectable transition of the magnetic object 100. The contact event and/or the at least one trigger event may be initiated by a user manipulation of the user-borne device 100 within a sensing volume. The contact event may be initiated by a contact of the user-borne device 100, more specifically of the at least one contact manipulation feature 170, with the interaction surface 210 and within the sensing volume. The contact event and/or the at least one trigger event may cause an action and/or may be used to control an action in a digital environment (i.e., an environment which is controlled by a computer or a network of computers), more specifically a virtual environment. The contact event may implement a user input or a physical contact of the at least one contact manipulation feature 170 with the interaction surface 210, which may be used for a precise definition of the interaction surface (location). It should be noted that in the present disclosure, the magnetic object 110 should be interpreted as at least one magnetic object and the contact event should be interpreted as at least one contact event.

The user-borne device 100 may be electrically and/or electronically passive. More specifically, electrically passive means that the user-borne device 100 may not comprise a power source (e.g., batteries) and/or means to receive power (e.g., wireless power transmission via an inductive coil) for powering a feature (e.g., an electronic feature) of the user-borne device 100. Electronically passive means that no computation or processing occurs (or happens) on the user-borne device 100.

The term "magnetic object" may refer to an object which may comprise components made of magnetic material, i.e., a material that has magnetic properties measurable by the plurality of magnetometers 300. The user-borne device 100 and/or the magnetic object 210 may be mobile, i.e., freely movable within a reference coordinate system XYZ as described below. In other words, during a user operation (i.e., an operation wherein the user-borne device 100 and/or the magnetic object 110 is operated by a user), the location of the user-borne device 100 within the sensing volume M and/or relative to an interaction surface 210 may be manipulated by a user within the sensing volume M.

The magnetic object 110 described herein may be at least one magnetic object 110. In other words, the user-borne device 100 may comprise additional magnetic objects. However, the embodiments described herein for the magnetic object 110 may also apply for the additional magnetic objects. The magnetic object 110 may be a permanent magnet. In embodiments, the magnetic object 110 may be configured to generate a non-zero magnetic field. It may comprise a paramagnetic or diamagnetic material. In embodiments, the magnetic object 110 may comprise a ferromagnetic material or a ferrimagnetic material. The magnetic object 110 may be configured to create or generate a symmetric magnetic field 115, more specifically wherein the magnetic field 115 may be rotationally symmetric. A rotation of the magnetic object 110 may thus be detectable about a first rotation axis 112 and a second rotation axis 114 of the magnetic object 110. However, a rotation about a third rotation axis (being perpendicular to the first rotation axis and the second rotation axis) may not be detectable since the magnetic field 115 may be rotationally symmetric. The magnetic object 110 may be axially magnetized in this case. However, in some embodiments, the magnetic object 110 may comprise a magnetization axis being at an orientation with respect to the magnetic object 110 such that a rotation of the magnetic field 115 may be detectable about a first rotation axis 112, a second rotation axis 114 and a third rotation axis 116 of the magnetic object 110. In this case the magnetic object 110 may be configured to create or generate an asymmetric magnetic field, more specifically wherein the magnetic field may be rotationally asymmetric. This may be the case for a magnetic object 110 being width magnetized or thickness magnetized.

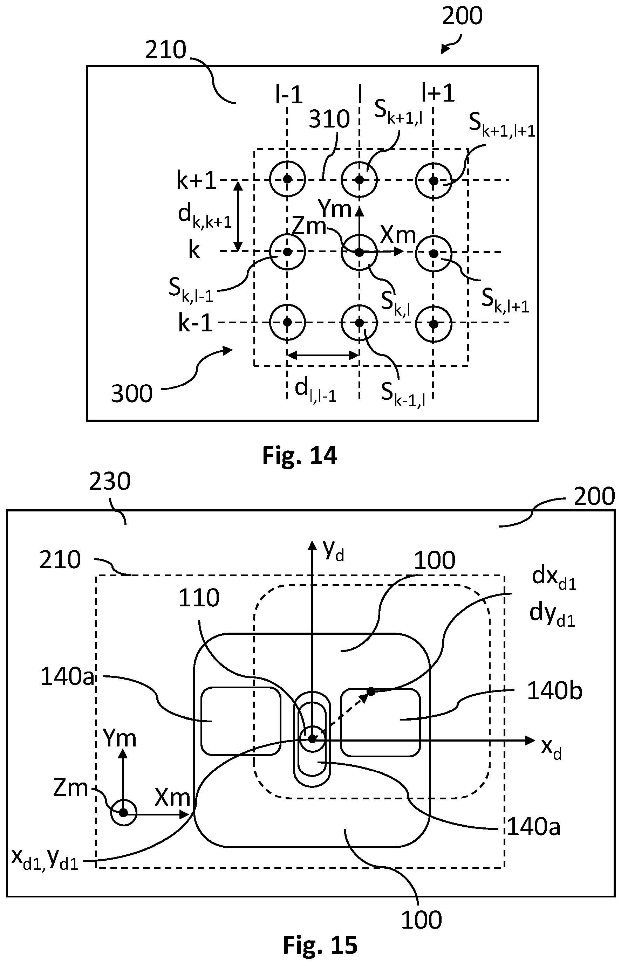

Referring to Figs. 1 to 13B, various embodiments of the user-borne device 100 are shown. The user-borne device 100 may a computer mouse, a keyboard, a toy, a stylus, or a dial. The user-borne device 100 may be operable on an interaction surface 210. Referring to Fig. 15, a movement of the user-borne device 100 on the interaction surface 10 is illustrated. The user-borne device 100 may be translatable on the interaction surface 210 along the first device axis x_{d} and/or the second device axis y_{q}. In this embodiment, the user-borne device 100 may be a computer mouse. During a user operation, the user-borne device 100 may be moved on the interaction surface 210 from a position x_{d1}, y_{d1} to a position dx_{d1}, dy_{d1}. The system 10 may be configured to track this movement based on determining the user-borne device location.

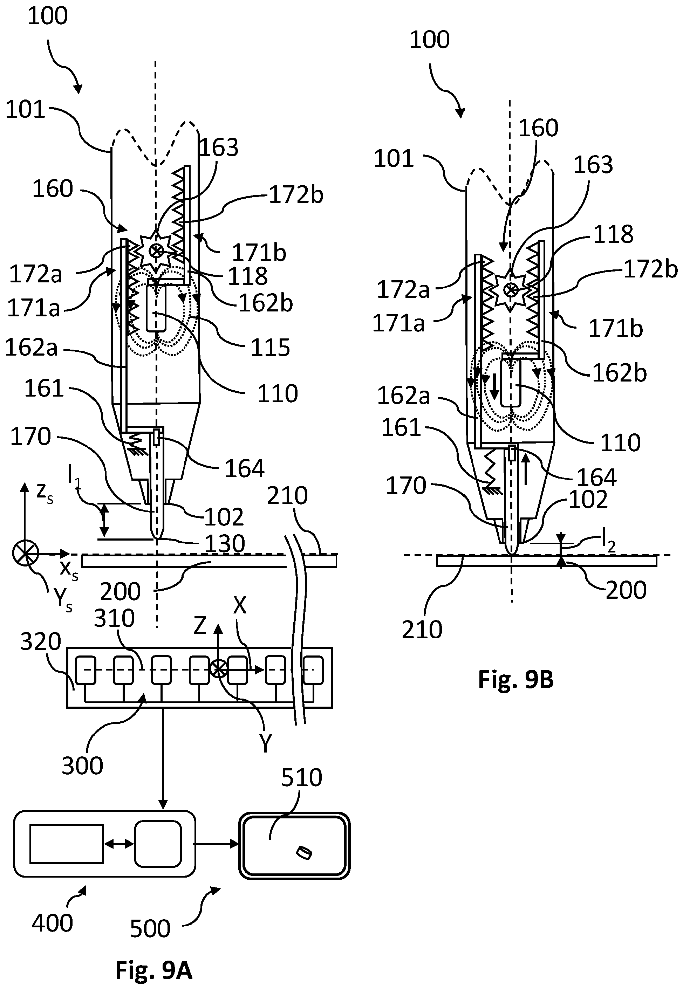

Referring to Fig. 1, the user-borne device 100, more specifically the housing 101, may comprise a device coordinate system. The device coordinate system may comprise a first device axis x_{d}, a second device axis y_{q} orthogonal to the first device axis x_{d}, and a vertical device axis z_{d}. The vertical device axis z_{d} may be orthogonal to a device contact surface or point 130 and/or orthogonal to a plane defined by the first device axis x_{d} and the second device axis y_{d}. The device contact surface or point 130 may be the part of the user-borne device 100 which, during a user operation, may be in contact with an interaction surface 210 (i.e., the surface on which the user-borne device 100 may be operated in some embodiments). In examples, e.g., as shown in Fig. 1, the user-borne device 100 may be a computer mouse and may comprise a contact surface 130 when contacting an interaction surface 210. In other examples (see, e.g., Figs. 9A and 9B), the user-borne device may comprise a contact point 130 (e.g., a stylus or other writing device comprising a writing tip with a nib which contacts an interaction surface 210 during a writing operation). In other examples, the user-borne device 100 may be operated within a sensing volume M but not on the interaction surface 210 (i.e., in the air). In this case, the user-borne device 100 may be used, e.g., as a pointer. In some embodiments, the device coordinate system may be defined within a geometric center of the user-borne device 100. As indicated in Fig. 1, the interaction surface 210 may comprise a first surface axis xₛ, a second surface axis yₛ, and a vertical surface axis zₛ, more specifically wherein the axes may be orthogonal with respect to each other. The first surface axis xₛ and the second surface axis yₛ may be defined on the interaction surface 210.

### Contact manipulation feature

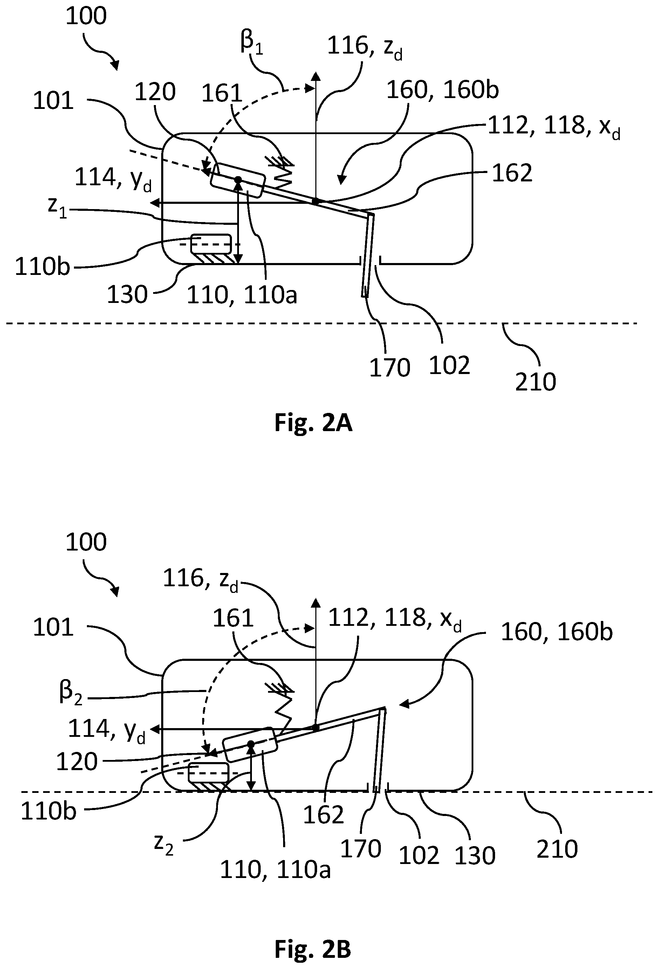

Figs. 2A to 9B are various embodiments of a user-borne device 100 according to aspects of the present disclosure. In these embodiments, the magnetic object 110 is transitioned from the first state to the second state in different ways, more specifically by providing different arrangements of the at least one contact manipulation feature 170 relative to the housing 101 and/or to the magnetic object 110.

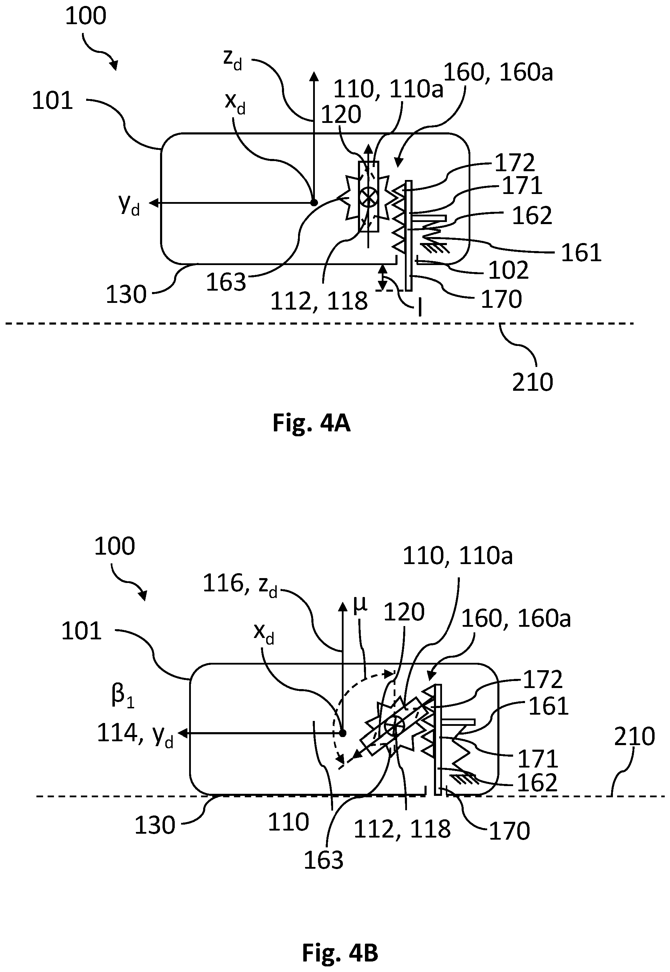

The at least one contact manipulation feature 170 may be arranged rotatable and/or translatable with respect to the housing 101. In the first state, the at least one contact manipulation feature 170 may be in a default location. The default location of the at least one contact manipulation feature 170 is shown, e.g., in Fig. 2A. In some embodiments, in the default location, the at least one manipulation feature 170 may be at least partially arranged within the housing 101. In the default location, a predominant part of the at least one manipulation feature 170 may be arranged within the housing 101. In the default location, at least a portion of the at least one manipulation feature 170 may be arranged outside the housing 101, e.g., protruding out of the housing 101 by a protruding distance 1 and/or beyond an outer surface of the housing 101 as shown in Figs. 2A and 4A.

In the second state, the at least one contact manipulation feature 170 may be in a contact location. The contact location may be different from the default location as shown, e.g., in Fig. 2B. More specifically, each of the default location and the contact location may comprise a respective position and/or orientation of the at least one contact manipulation feature 170 relative to the housing 101. An actuation of the at least one contact manipulation feature 170 may cause a movement of the at least one contact manipulation feature 170 from the default location to the contact location. In the default location, the at least one contact manipulation feature 170 may protrude further out (and beyond the outer surface) of the housing 101 than in the contact location. In some embodiments, in the contact location, the at least one contact manipulation feature 170 may be substantially flush with the outer surface of the housing 101. In the first state, the at least one contact manipulation feature 170 and/or the device contact surface 130 may be distanced to the interaction surface 210. Thus, the first state is indicative of the user-borne device 100 being distanced to the interaction surface 210. In the second state, the at least one contact manipulation feature 170 and/or the device contact surface 130 may be in contact with the interaction surface 210. Thus, the second state is indicative of the user-borne device 100 being in contact with the interaction surface 210. In other words, in the default location, the at least one contact manipulation feature 170 and/or device contact surface or point 130 may be distanced to the interaction surface 210. In the contact location, the at least one contact manipulation feature 170 and/or device contact surface or point 130 may be in contact with the interaction surface 210.

As mentioned above, the housing 101 may comprise an outer surface. A portion of the outer surface may be a device contact surface 130. The housing 101 may comprise an opening 102 in the outer surface through which the at least one contact manipulation feature 170 may be movable. In the first state, the at least one manipulation feature 170 may at least partially protrude through the opening 102 and out of the housing 101. In some embodiments, the opening 102 may be provided in the device contact surface 130. In embodiments, the opening 102 may be provided in a surface other than the device contact surface, e.g., a side surface or a top surface of the housing 101. As will be described in detail below, the user-borne device 100 may comprise a click manipulation feature 150 and/or a scroll manipulation feature 140 (see, e.g., Fig. 1). The device contact surface 130 may be the surface, which may be in contact with the interaction surface 210 when the user-borne device 100 is operated on the interaction surface 210. The click and/or scroll manipulation features 140, 150 may be provided at outer surfaces of the user-borne device 100 not being the surface which is in contact with the interaction surface (i.e., the device contact surface 130). It should be noted that the user-borne device 100 could be accidentally placed upside down on the interaction surface 210 by a user. However, the device contact surface 130 may be the surface configured to provide the user-borne device 100 with the most stable and secure support possible on the interaction surface 210. The device contact surface 130 may be the surface which defines a plane that is substantially parallel to the interaction surface 210.

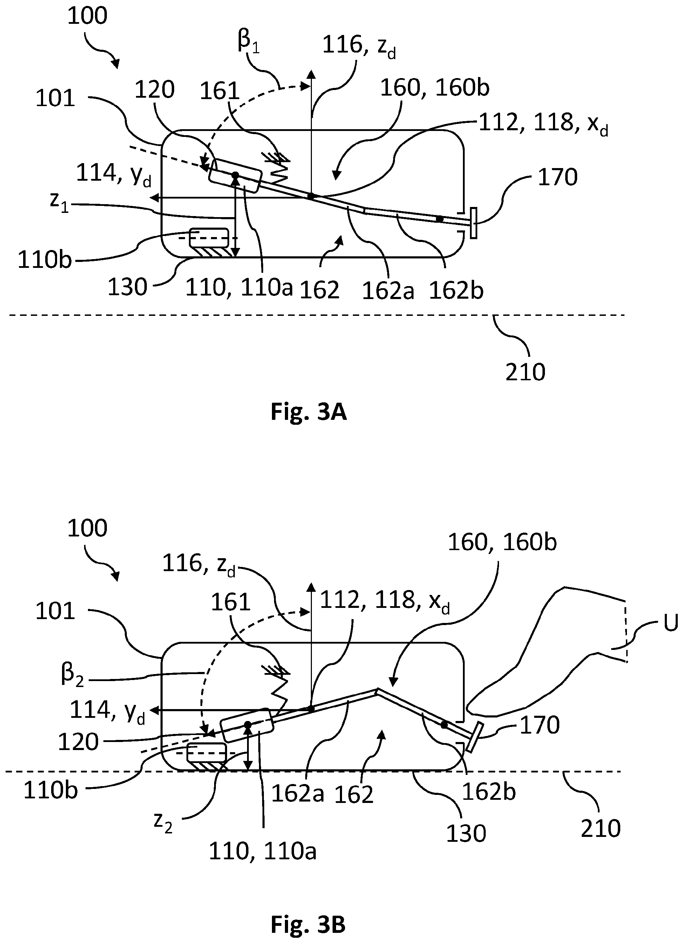

The actuation of the at least one contact manipulation feature 170 may be provided by applying a force on the at least one contact manipulation feature 170. In some embodiments, the at least one contact manipulation feature 170 may be actuatable by a user U, as shown in Figs. 3A and 3B. Thus, the transition may be caused based on an actuation of the at least one contact manipulation feature 170 by the user U. In this embodiment, the at least one contact manipulation feature 170 may be arranged with respect to the housing 101 such that the at least one contact manipulation feature 170 may be accessible by a user in the default location and/or the contact location. The at least one contact manipulation feature 170 may be accessible at the device contact surface 130 or may be accessible at an outer surface of the housing 101 other than the device contact surface 130. In some embodiments, the at least one manipulation feature 170 may comprise a button and/or a switch arranged on an outer surface of the housing 101, e.g., on a device contact surface 130, a side surface and/or a top surface of the housing 101). In this embodiment, the at least one contact manipulation feature 170 (i.e., at least the portion accessible by the user) may be pressed or slid by a user when the user-borne device 100 when a contact event with the interaction surface 210 should be indicated. Thus, a force may be applied on the at least one contact manipulation feature 170 causing a transition of the magnetic object 110. More specifically, when applying the force, the at least one manipulation feature 170 may be configured to rotate and/or translate into the housing 101. This may cause the transition of the magnetic object 110. The transition may indicate a contact event, which in turn may be detectable with the plurality of magnetometers 300.

In some embodiments, e.g., as shown in Figs. 2A, 2B and 4A to 9B, the at least one contact manipulation feature 170 may be arranged with respect to the housing 101 such that a contact of the housing 101 and/or at least one contact manipulation feature 170 with the interaction surface 210 may cause the actuation of the at least one contact manipulation feature 170, more specifically from the default location to the contact location. In case the at least one contact manipulation feature 170 may physically contact the interaction surface 210, a force may be applied on the at least one contact manipulation feature 170. This in turn may cause a movement of the at least one contact manipulation feature 170 from the default location to the contact location. Furthermore, this may cause the transition of the magnetic object 110 indicating a contact event, which may be detectable with the plurality of magnetometers 300. The at least one manipulation feature 170 may be configured to rotate and/or translate into the housing 101 when contacting the interaction surface 210 (i.e., when a force is applied on the at least one manipulation feature 170). In the first state, the at least one contact manipulation feature 170 may protrude out of the housing 101 through the opening 102 and beyond the device contact surface 130. In particular, the at least one contact manipulation feature 170 may be arranged within the housing 101 and a portion of the at least one contact manipulation feature may protrude out of the housing 101 in the first state. The at least one manipulation feature 170 may be distanced to the interaction surface 210 in the first state. In the second state, the at least one contact manipulation feature 170 may be rotated and/or translated into the housing 101, more specifically due to the contact with the interaction surface 210 applying a force on the at least one contact manipulation feature 170. It should be noted that a slight contact of the at least one contact manipulation feature 170 with the interaction surface or a slight actuation by a user may cause only a slight movement of the at least one contact manipulation feature 170. Due to the interaction with the magnetic object 110, the slight movement of the at least one contact manipulation feature 170 may only cause a slight transition of the magnetic object 110. The system 10 may set a threshold for a detected transition to ensure that a contact event is indeed present. Possible thresholds will be described in detail below.

In some embodiments (not shown in the Figs.), the housing 101 may comprise a flexible portion that may be elastically deformable when a force is applied on the flexible portion. The flexible portion may protrude from the outer surface of the housing 101 (i.e., protrude away from the housing 101). In some embodiments, the flexible portion may be arranged on the device contact surface 130. The (more specifically entire) at least one contact manipulation feature 170 may be arranged within the housing. The flexible portion may be arranged with respect to the at least one contact manipulation feature 170 such that a force applied on the flexible portion from outside the housing 101 may cause an actuation of the at least one contact manipulation feature 170. The force applied to the flexible portion may be provided by a user pressing on the flexible portion or a contact of the housing 101 and/or flexible portion with the interaction surface 210 (e.g., by a physical contact with the interaction surface 210, or an actuation applied by a user on the flexible portion). In embodiments, gravitational forces acting on the user-borne device 100 (i.e., based on its weight) and the physical contact with the interaction surface 210 may be sufficient to apply the force on the flexible portion. In the above embodiments, the at least one contact manipulation feature 170 may be in indirect contact with the interaction surface 210 and/or a user. In the default position, the flexible portion may protrude from the outer surface of the housing 101. In the contact location, the flexible portion may be deformed towards to the outer surface and may protrude less from the outer surface than in the default position. The movement of the flexible portion may be transmitted to the at least one contact manipulation feature 170 due to the physical contact between the flexible portion and the at least one contact manipulation feature 170. "Elastically deformable" means that the flexible portion may be able to regain its original shape in the default location (i.e., when no force is applied on the flexible portion). The flexible portion may be mechanically connected to the at least one contact manipulation feature 170.

### Transmission device

The user-borne device 100 may comprise a transmission device 160 operatively coupled to the at least one contact manipulation feature 170. Embodiments of the transmission device 160 are schematically illustrated in Figs. 1 to 9B.

The transmission device 160 may be configured to interact with the magnetic object 110 such that the magnetic object 110 may be transitioned from the first state to the second state when the at least one manipulation feature 170 is actuated. As also shown, e.g., in Fig. 2A, the transmission device 160 may comprise at least one biasing mechanism 161. The biasing mechanism may be at least one first biasing mechanism. The biasing mechanism may be configured to urge the at least one contact manipulation feature 170 to the default location when the at least one manipulation feature 170 is not actuated. "Not actuated" means, that no force is applied on the at least one contact manipulation feature 170 (e.g., due to a physical contact of the at least one manipulation feature 170 with the interaction surface 210 and/or due to a force applied on the at least one manipulation feature 170 by a user U). In some embodiments, the at least one biasing mechanism may comprise a spring element. In other embodiments, the at least one biasing mechanism may be provided as a weight coupled to the at least one contact manipulation feature 170 such that the at least one contact manipulation feature 170 may be urged to the default location due to gravitational forces acting on the weight. However, this may only be the case when the weight and/or the at least one contact manipulation feature 170 is oriented towards the device contact surface 130 being below the user-borne device 100.

As shown in Figs. 2A to 9B, the magnetic object 110 or a magnetic field modification element 164 (which will be described in detail below) may be operatively coupled to the transmission device 160. The transmission device 160 may be configured to transmit a rotation and/or translation of the at least one contact manipulation feature 170 to the magnetic object 110 or to the modification element 164. In other words, a rotation and/or translation of the at least one manipulation feature 170 may cause a predefined rotation and/or translation of the magnetic object 110 or the modification element 164. The transmission device 160 may comprise a gear transmission 160a and/or a lever transmission 160b. The at least one biasing mechanism 161 as described above may be configured to urge the magnetic object 110 to the first location, when the at least one contact manipulation feature 170 is distanced to the interaction surface 110. In some embodiments, the transmission device 160 may comprise at least one second biasing mechanism configured to urge the magnetic object 110 to the first location, when the at least one contact manipulation feature 170 is distanced to the interaction surface 110. The at least one biasing mechanism 161 or at least one third biasing mechanism may be configured to urge the modification element 164 to an exposed location or a covered location, which however, will be described in detail below.

In some embodiments, e.g., as shown in Figs. 2A to 3B, the lever transmission 160b may comprise at least one lever member 162 rotatable about at least one transmission rotation axis 118. In other words, the at least one lever member 162 may be rotatably coupled to the housing 101. The at least one lever member 162 may be coupled to the magnetic object 110 at a first end of the at least one lever member 162, and to the at least one contact manipulation feature 170 at a second end of the at least one lever member 162. The at least one lever member 162 may be fixedly or rotatably coupled to the magnetic object 110. In some embodiments, the at least one lever member 162 may be rotatably and/or translatably coupled to the magnetic object 110. The at least one contact manipulation feature 170 may be fixedly or rotatably coupled to the lever member. In some embodiments, the at least one lever member 162 may be rotatably and/or translatably coupled to the at least one contact manipulation feature 170. The transmission rotation axis 118 may be parallel to the first rotation axis 112 and/or the first device axis x_{d}. In some embodiments the transmission rotation axis 118 may be parallel to the second device axis y_{d}. The at least one biasing mechanism 161 as described above may be coupled to the at least one lever member 162 and to the housing 101. In the embodiment of Figs. 2A to 3B, the at least one lever member 162 may be fixedly coupled to the magnetic object 110 and rotatably coupled to the at least one contact manipulation feature 170. As shown in Figs. 3A and 3B, the at least one lever member 162 may comprise a first lever member 162a and at least one second lever member 162b operatively coupled to the first lever member 162a. The first lever member 162a may be fixedly or rotatably coupled to the magnetic object 110. The first lever member 162a may be rotatably and/or translatably coupled to the at least one second lever member 162b. The at least one second lever member 162b may be fixedly or rotatably coupled to the at least one contact manipulation feature 170.

Referring to Figs. 4A, 4B, 7A, 7B, and 8A to 9B, the transmission device 160 may comprise a gear transmission 160a comprising at least one gear wheel 163 via which the at least one contact manipulation feature 170 may be operatively coupled with the magnetic object 110 or the modification element 164. The at least one gear wheel 118 may be rotatable about the at least one transmission rotation axis 118. In some embodiments, the at least one gear wheel 163 may be coupled to the magnetic object 110 such that a rotation of the at least one gear wheel 163 may cause a rotation and/or a translation of the magnetic object 110. As shown e.g., in Figs. 4A, 4B 8A and 8B, the magnetic object 110 may be fixedly coupled the at least one gear wheel 163 such that a rotation of the at least one gear wheel 163 may cause a corresponding rotation of the magnetic object 110. The first rotation axis 112 or the second rotation axis 114 of the magnetic object 110 may be parallel to the at least one transmission rotation axis 118 or may be the same as the at least one transmission rotation axis 118. A rotation of the at least one gear wheel 163 may cause a rotation of the magnetic moment vector 120. The at least one transmission rotation axis 118 may be inclined or perpendicular to the magnetic moment vector 120.

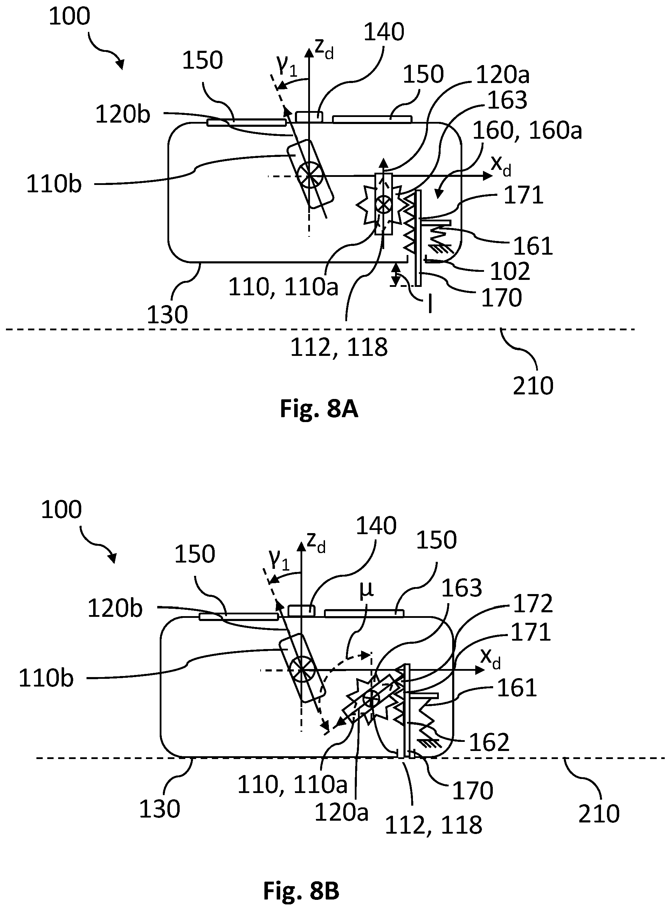

As shown in Figs. 4A, 4B, 7A, 7B, and 8A to 9B, the transmission device 160 may comprise a lever transmission 160b and a gear transmission 160a as described above. The lever transmission 160a, more specifically the at least one lever member 162, may comprise at least one actuation element 171 with one or more engagement features 172. The actuation element 171 may be coupled to the at least one contact manipulation feature 170, more specifically via the at least one lever member 162. The one or more engagement features 172 may be operatively coupled with the gear wheel 163 such that a translation (and/or rotation) of the at least one contact manipulation feature 170 and/or of the actuation element 171 may cause a rotation of the gear wheel 163. As indicated in Figs. 4B and 8B, the transmission device 160 may be configured such that, when the at least one contact manipulation feature 170 is actuated, the at least one gear wheel 163 and/or the magnetic object 110 may be rotated by a gear wheel rotation angle µ from 10° to 360°, more specifically from 45° to 220°, and particularly from 90° to 180°. In embodiments, when the at least one contact manipulation feature 170 is actuated, the at least one gear wheel 163 and the magnetic object 110 may be rotated by a gear wheel rotation angle µ from 10° to 360°, more specifically from 45° to 220°, and particularly from 90° to 180°. Thus, an orientation of the magnetic object may transition from a first state to a second state (i.e., the transition may comprise a location change which will be described in detail below). The transition may be associated with a contact event of the user-borne device with the interaction surface. Due to the gear wheel rotation angle as defined above, such movement (i.e., the rotation) of the magnetic object 110 may be distinguished from other rotations of the magnetic object, e.g., due to normal user operations of the user-borne device (like tilting the user-borne device 100 in the air or on the interaction surface 210). The at least one gear wheel 163 may comprise a first orientation in the first state and a second orientation in the second state, wherein the at least one biasing mechanism 161 may be configured to urge the at least one gear wheel 163 to the first orientation when the at least one contact manipulation feature 170 is distanced to the interaction surface 210.

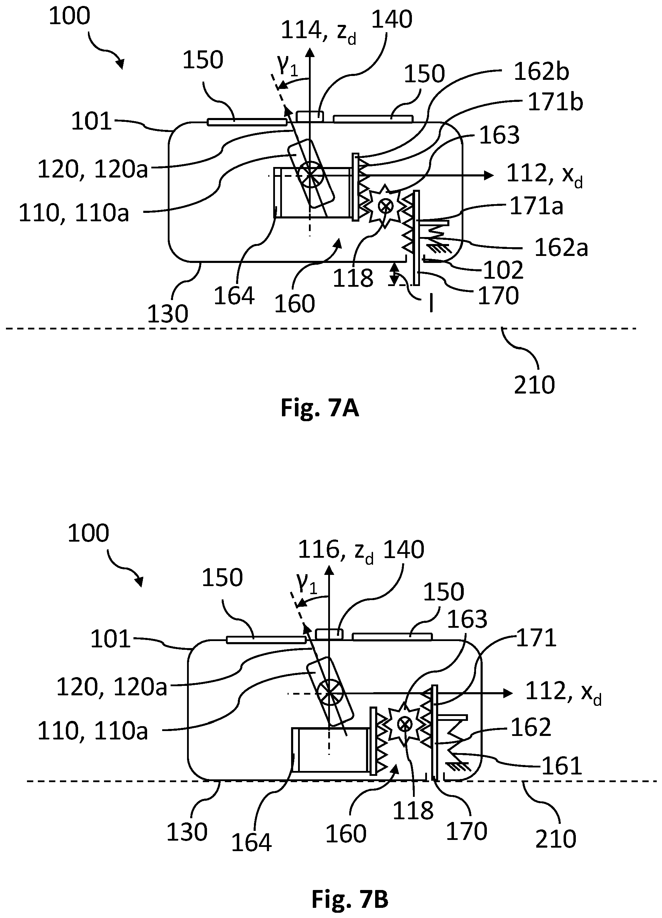

In the embodiments shown in Figs. 7A, 7B, 9A and 9B, the transmission device 160 may comprise the at least one gear wheel 163, the first lever member 162a, the at least one second lever member 162b, and the at least one actuation element 171. The at least one actuation element 171 may comprise a first actuation element 171a with first one or more engagement features 172a and at least one second actuation element 172b with second one or more engagement features 172b. The first lever member 162a may be coupled to the at least one contact manipulation feature 170 and may be operatively coupled to the at least one gear wheel 163 via the first actuation element 171a due to the engagement of the first one or more engagement features 172a with the gear wheel 163. Of course, additional lever members as described above may be provided between the at least one contact manipulation feature 170 and the at least one gear wheel 163. The at least one second lever member 162a may be operatively coupled to the at least one gear wheel 163 via the second actuation element 172a due to the engagement of the second one or more engagement features 172b with the gear wheel 163. Thus, the at least one gear wheel 163 may operatively couple the first lever member 162a with the at least one second lever member 162b. In the embodiment of Figs. 7A and 7B, the at least one second lever member 162b may be coupled, more specifically fixedly coupled, with the modification element 164. In the embodiment of Figs. 9A and 9B, the at least one second lever member 162b may be coupled, more specifically fixedly coupled, with the magnetic object 110. Thus, the at least one contact manipulation feature 170 may be operatively coupled to the magnetic object 110 or the modification element 164 such that an actuation of the at least one contact manipulation feature 170 may cause a translation of the magnetic object 110 or the modification element 164, more specifically towards the interaction surface 210, particularly towards the device contact surface or point 130. Additionally or alternatively, in some embodiments, the at least one contact manipulation feature 170 may be operatively coupled to the magnetic object 110 or the modification element 164 such that an actuation of the at least one contact manipulation feature 170 may cause a rotation of the magnetic object 110 or the modification element 164.

### Transition of the magnetic object

As mentioned above, Figs. 1 to 9B illustrate various embodiments of a user-borne device 100 according to aspects of the present disclosure. In these embodiments, the magnetic object 110 may be transitioned from the first state to the second state in various ways. In the following, possible transitions of the magnetic object 110 will be described in more detail.

The magnetic object 110 may be configured to create a magnetic field. The transition of the magnetic object 110 from the first state to the second state may be detectable based on magnetic field measurements with a plurality of magnetometers 300. The transition of the magnetic object 110 may comprise a location change and/or a magnetic field change. The respective embodiments of the location change and/or magnetic field change will be explained in detail with reference to Figs. 2A to 9B below. In some embodiments, the user-borne device 100 may be configured to control a contact event detectable with a plurality of magnetometers 300 based on the transition caused by an actuation of the at least one contact manipulation feature 170.

In some embodiments as shown in Figs. 2A to 5B, and 8A to 9B, the transition may comprise a location change of the magnetic object 110 relative to the housing 101. Thus, the magnetic object 110 may be movably coupled to the housing 101. More specifically, the magnetic object 110 may be arranged rotatable and/or translatable with respect to the housing 101. The magnetic object 110 may be arranged within the housing 101. The at least one contact manipulation feature 170 may be mechanically coupled to the magnetic object 110, more specifically via the transmission device 160. The location change may comprise a movement of the magnetic object 110 relative to the housing 101. The location change may be predetermined and/or limited by the geometric (or mechanical) design and associated conditions of the housing 101. In other words, the location change may be known or expected because it may be limited by the specific geometry and mechanical conditions of the housing 101 which may not be misinterpreted by the system as another interaction. More specifically, the movement may comprise a rotation and/or translation of the magnetic object 110 relative to the housing 101. The location change of the magnetic object 110 may comprise a movement of the magnetic object 110 from a first location to a second location relative to the housing 101. In detail, the at least one contact manipulation feature 170 may be mechanically coupled to the magnetic object 110 via the transmission device 160 such that an actuation of the at least one contact manipulation feature 170 may cause a translation and/or rotation of the magnetic object 110 from the first location to the second location. In other words, the actuation of the at least one contact manipulation feature 170 may cause the location change of the magnetic object 110. The location of the magnetic object 110 may comprise a position and/or an orientation of the magnetic object 110 relative to the housing 101. The position and/or orientation of the magnetic object 110 relative to the housing 101 may change when the at least one contact manipulation feature 170 is actuated. In the first state, the magnetic object 110 may be at the first location (see, e.g., Fig. 2A) and in the second state, the magnetic object 110 may be at the second location (see, e.g., Fig. 2B), more specifically wherein the second location may be different from the first location. The location change from the first location to the second location may be defined by the movement, more specifically the rotation and/or translation of the magnetic object 110. The first location and the second location may each comprise a respective position and/or orientation of the magnetic object 110 relative to the housing 101. The location change and/or movement of the magnetic object 110 may be indicative of the contact event. More specifically, the location change and/or movement may be detectable based on magnetic field measurements associated with the magnetic object 110 with the plurality of magnetometers 300. The contact event may be determined based on the detected location change. More specifically, the system 10 may be configured to determine the contact event based on the detected transition, more specifically based on the detected location change and/or movement.

The movement of the magnetic object 110 relative to the housing 101 may be a predefined movement. The predefined movement may comprise a predefined translation and/or rotation of the magnetic object 110 relative to the housing 101. The predefined movement may be indicative of the contact event and may be detectable with the plurality of magnetometers 300. In embodiments, the movement may comprise a movement trajectory, a movement velocity range, and/or a movement time range. In embodiments, the movement may be associated with a movement trajectory (e.g., a predefined movement trajectory) which can be provided by the rotation and/or translation of the magnetic object, more specifically from the first location to the second location. An actuation of the at least one contact manipulation feature may lead to a specific movement trajectory, movement velocity range and/or movement time range. Due to the mechanical coupling of the magnetic object 110 with the transmission device 160, the housing 101 and/or the at least one contact manipulation feature 170, the movement of the magnetic object 110 may be predefined. The movement trajectory, movement velocity range and/or movement time range may be linked with a contact event, e.g., when the at least one contact manipulation feature 170 contacts the interaction surface 210 or is actuated by a user. In case the movement trajectory, movement velocity range and/or movement time range is detected with the plurality of magnetometers, a contact event may be determined. The movement trajectory may be defined by a combination of a rotation and a translation of the magnetic object 110 relative to the housing 101. The combined translation and rotation may define the movement trajectory during transition and may be indicative of the contact event. The movement trajectory may be associated with a first direction, indicating a "contact on" event (i.e., wherein the user-borne device 100, more specifically the at least one contact manipulation feature 170, may be in contact with the interaction surface 210). The movement trajectory may be associated with a second direction opposite the first direction, indicating a "contact off" event (i.e., wherein the user-borne device 100, more specifically the at least one contact manipulation feature 170, may be distanced the interaction surface 210). It should be noted that the movement of the magnetic object, e.g., the movement trajectory, may be limited by mechanical constraints and/or the shape of the housing 101 within which the magnetic object 110 may be arranged. The magnetic object 110 may be arranged within the housing 101 such that the movement, e.g., the movement trajectory, of the magnetic object 110 due to the actuation of the at least one contact manipulation feature 170 may be clearly distinguished, e.g., from a movement of the magnetic object caused by an actuation of a click manipulation feature 150 and/or a scroll manipulation feature 140 which will be described in detail below. In some embodiments, a distance between the first location and the second location may be at least 2 mm. In embodiments, the movement time range may be at least 2ms.

Referring e.g., to Figs. 2A and 2B, during transition from the first location to the second location, the magnetic object 110 may be translated and/or rotated towards a device contact surface 130. More specifically, the magnetic object 110 may be rotated about the at least one transmission rotation axis 118 and translated towards the device contact surface 130 from the first location to the second location when the at least one contact manipulation feature 170 is actuated. In this case, in the second location, the magnetic object 110 is closer to the interaction surface 210 than in the first location. In some embodiments the plurality of magnetometers may be arranged below the interaction surface 210 and a strength of the magnetic field created by the magnetic object 110 may be seen stronger in the second location than in the first location - which may be indicative of the contact event. As indicated in Figs. 2A to 3B and as mentioned above, the magnetic object 110 may define a magnetic moment vector 120 which may be associated with the magnetic field created by the magnetic object 110. In the first location, a first angle β₁ may be defined between the magnetic moment vector 120 and the vertical device axis z_{d}. In the second location, a second angle β₂ may be defined between the magnetic moment vector 120 and the vertical device axis z_{d}. The second angle β₂ may be larger than the first angle β₁. In other words, due to the contact of the at least one contact manipulation feature 170 with the interaction surface 210, a force applied on the at least one contact manipulation feature 170 may be transmitted to the transmission device 160, which in turn may rotate and/or translate the magnetic object 110 from the first location to the second location. The vertical device axis z_{d} may be orthogonal to the device contact surface 130. During transition, the orientation of the magnetic object (i.e., defined by the first angle β₁ and the second angle β₂) may change relative to and/or within the housing 110. In some embodiments (not shown in Figs. 2A to 3B), in the first location, the magnetic moment vector 120 may be substantially perpendicular to the vertical device axis z_{d}. In some embodiments (not shown in Figs. 2A to 3B), in the second state, the magnetic moment vector 120 may be substantially parallel to the vertical device axis z_{d}.

Referring back to Figs. 2A to 3B, in the first location, a first distance z₁ may be defined between a center of the magnetic object 110 and the device contact surface 130. In the second location, a second distance z₂ may be defined between the center of the magnetic object 110 and the device contact surface 130. The second distance z₂ may be smaller than the first distance z₁. The center may be a geometric center. The center may be known due to the mechanical arrangement of the magnetic object 110 within the housing 101 and/or due to the shape of the magnetic object 110. In some embodiments, the center of the magnetic object 110 may be the barycenter of the magnetic object 110. The center of the magnetic object 110 may be determined based on magnetic field measurements with the plurality of magnetometers. As shown in Figs. 2A to 3B, the first distance z₁ and the second distance z₂ may be measured parallel to the vertical device axis z_{d}. In other words, in the second state the magnetic object 110 may be closer to the interaction surface 210 due to the rotation and/or translation of the magnetic object 110 towards the device contact surface 130. During transition, a position of the least one magnetic object 110 may change within the housing 101.

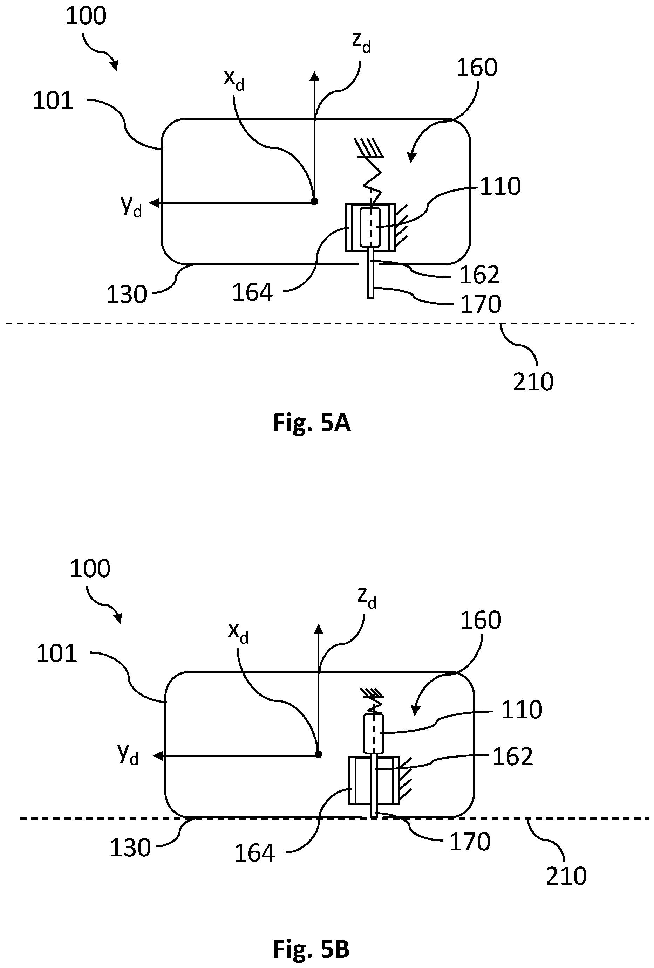

As described above, the magnetic object 110 may be configured to create or generate a magnetic field 115. In some embodiments as indicated in Figs. 5A to 7D, the transition may comprise a magnetic field change of the magnetic object 110 detectable based on magnetic field measurements with the plurality of magnetometers 300. The magnetic field change may be detectable outside the user-borne device 100, more specifically the housing 101, with the plurality of magnetometers 300. Outside the user-borne device 100, more specifically the housing 101, means an environment of the user-borne device 100. However, it is not necessary that the magnetic field change be detectable all around the user-borne device 100. Rather, the magnetic field change is detectable at least at one location (e.g. a spatial angle range) outside the user-borne device 100, in particular outside the housing 101. The magnetic field change of the magnetic object 110 may be indicative of the contact event. The contact event may be determinable on the basis of the detected magnetic field change, more specifically outside the housing 101. It should be noted that the magnetic properties of the magnetic object 110 may not change due to the transition. However, during transition, the resulting magnetic field seen and measured by the magnetometers may change. The magnetic field change may also be described with a magnetic object signature the magnetic object 110 may have in the first state and the second state, and which may change during transition. The magnetic signature of a magnetic object 110 may have distinctive characteristics making it possible to distinguish the magnetic object 110 from other magnetic objects, as well as to distinguish a first magnetic signature in the first state of the magnetic object 110 and a second magnetic signature in the second state of the magnetic object 110. The first and second magnetic signatures as well as the magnetic signature transition may be detectable outside the housing 101 with the plurality of magnetometers 300. Each magnetic signature may comprise a set of vectors describing a magnetic object vector field of the magnetic object 110 in the first and second states. As mentioned above, the magnetic field 115 may comprise a magnetic field strength and/or a magnetic field form. The transition may comprise a change of the magnetic field strength and/or a change of the magnetic field form. The magnetic object 110 may comprise the magnetic object moment vector 120 and/or a magnetic object position vector associated with the magnetic field 115. In other words, the magnetic object 110 may be modeled as a magnetic dipole being defined by the magnetic object moment vector 120 and/or the magnetic object position vector. The magnetic object moment vector 120 and/or the magnetic object position vector may be used to determine the magnetic field change. The magnetic object moment vector 120 may define a magnetic object orientation and/or a magnetic object strength, i.e., the magnetic field strength of the magnetic object 110. The magnetic object strength may be related to the magnetization of the magnetic object 110 and its volume. The magnetic field form may be indicative of a 3D form of the magnetic field associated with the magnetic object 110. The change of the magnetic field strength and/or a change of the magnetic field form may occur due to another object being brought in proximity to (or away from) the magnetic object 110. The other object may have an influence (i.e., change) the magnetic field strength and/or the magnetic field form of the magnetic object 110. The magnetic field form may be defined by the magnetic object signature and the magnetic object vector field as described above, and which is detectable with the plurality of magnetometers. During transition (i.e., the magnetic field change), the magnetic object vector field may change which may be detectable, more specifically outside the housing 101, with the plurality of magnetometers 300.

Referring to Figs. 5A to 7D, in the first state the magnetic object 110 may comprise a first magnetic field. In the second state, the magnetic object 110 may comprise a second magnetic field. The second magnetic field may be different from the first magnetic field. The first magnetic field may be the magnetic field 115 in the first state, and the second magnetic field may be the magnetic field 115 in the second state. The first magnetic field may be the magnetic field 115 at a first point of time t1. The second magnetic field may be the (same) magnetic field 115 at a second point of time t2, wherein t2>t1. The first magnetic field measured with the plurality of magnetometers at t1 may be different from the second magnetic field measured with the plurality of magnetometers at t2>t1. In other words, in the first state the magnetic object may have a first magnetic object vector field detectable with the plurality of magnetometers and in the second state the magnetic object may have a second magnetic object vector field detectable with the plurality of magnetometers. The transition may comprise a magnetic field change of the magnetic object 110 from the first magnetic field to the second magnetic field. More specifically, the first magnetic field may comprise a first magnetic field strength and/or a first magnetic field form. The second magnetic field may comprise a second magnetic field strength and/or a second magnetic field form. The second magnetic field strength may be larger or smaller than the first magnetic field strength and/or the second magnetic field form may be different from the first magnetic field form (i.e., the magnetic object vector fields may be different).

The transition comprising a magnetic field change may be provided in several ways. Some embodiments will be described with reference to Figs. 5A to 7D, 9A and 9B. The user-borne device 100 may comprise a magnetic field modification element 164 configured to magnetically interact with the magnetic object 110, more specifically with the magnetic field created by the magnetic object 110. "Magnetically interact" means that the magnetic field modification element 164 may affect (or have an impact on) the magnetic field 115 created by the magnetic object 110, more specifically depending on a location of the magnetic field modification element 164 relative to the magnetic object 110. The magnetic field modification element 164 may affect the magnetic object vector field (and its directions) measured with the plurality of magnetometers. Thus, the modification element 164 may be configured to change the magnetic field created by the magnetic object 110 depending on a location of the modification element 164 relative to the magnetic object 110. In embodiments, one of the magnetic object 110 and the modification element 164 may be operatively coupled to the at least one contact manipulation feature 170 and configured to change its location with respect to the respective other one of the magnetic object 110 and the modification element 164, when the at least one manipulation feature 170 is actuated. The magnetic object 110 may be movable relative to the modification element 164. At least one of the magnetic object 110 and the modification element 164 may be movable relative to the housing 101. In some embodiments, each of the magnetic object 110 and the modification element 164 may be movable relative to the housing 101. Each of the modification element 164 and the magnetic object 110 may be arranged within the housing 101.

In some embodiments as shown in Figs. 5A and 5B, the modification element 164 may be fixedly coupled to the housing 101 and the magnetic object 110 may be movably coupled to the housing 101. The magnetic object 110 may be operationally coupled to the at least one contact manipulation device 170. In this case, the magnetic object 110 may be mechanically coupled with the at least one contact manipulation feature 170, more specifically via the transmission device 160. The transmission device 160 may be fixedly coupled with the magnetic object 110 and/or the at least one contact manipulation feature 170.

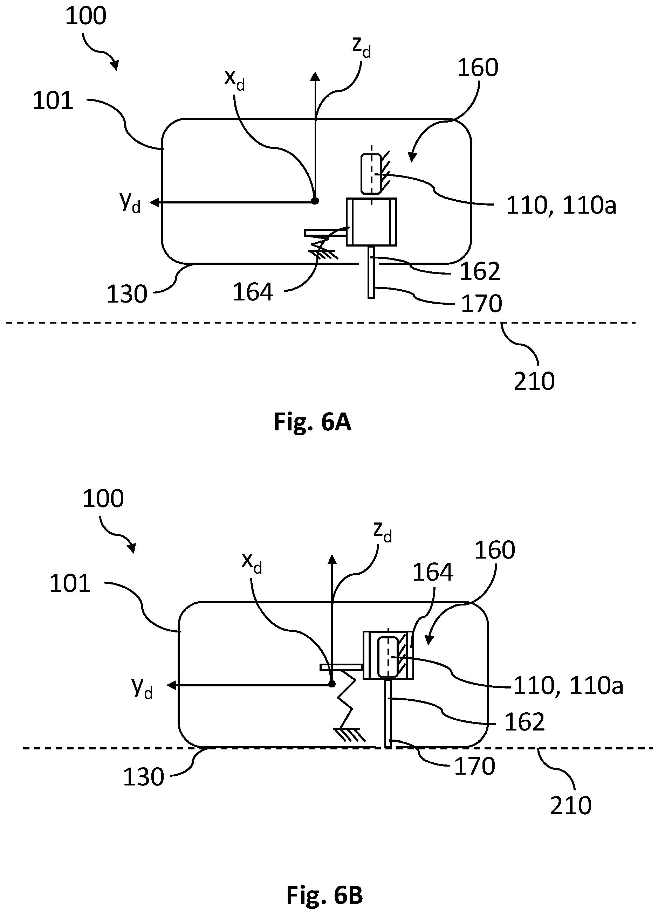

In some embodiments as shown in Figs. 6A and 6B, the modification element 164 may be movably coupled to the housing 101 and the magnetic object 110 may be fixedly coupled to the housing 101. The modification element 164 may be operationally coupled to the at least one contact manipulation device 170. In this case, the modification element 164 may be mechanically coupled with the at least one contact manipulation feature 170, more specifically via the transmission device 160. The transmission device 160 may be fixedly coupled with the modification element 164 and/or the at least one contact manipulation feature 170.

In some embodiments as shown in Figs. 7A to 8B, the modification element 164 and the magnetic object 110 may be movably coupled to the housing 101. The modification element 164 may be operationally coupled to the at least one contact manipulation device 170. In this case, the modification element 164 may be mechanically coupled with the at least one contact manipulation feature 170, more specifically via the transmission device 160 as described above.

The modification element 164 may be configured to enhance or attenuate the magnetic field created by the magnetic object 110. In some embodiments, the modification element 164 may be configured to create (or generate) an additional magnetic field detectable outside the user-borne device 100, more specifically the housing 101, with the plurality of magnetometers 300, which will be described in more detail below. In some embodiments, the modification element 164 may comprise a magnetic material. The magnetic material may be a paramagnetic material, a diamagnetic material, or a ferromagnetic material. The ferromagnetic material can be magnetized by an external magnetic field. When the ferromagnetic material is placed in a magnetic field, areas of the ferromagnetic material may align themselves with this magnetic field. The magnetization process may locally disturb the magnetic flux density of the magnetic field 115 created by the magnetic object 110. The ferromagnetic material of the modification element 164 may become itself a magnet and may disturb locally the magnetic field 115 created by the magnetic object 110. The magnetic field 115 applied to the ferromagnetic material may lead to a magnetization of the ferromagnetic material. However, this may only happen in case the magnetic field is strong enough, i.e., when the magnetic object 110 creating the magnetic field and the ferromagnetic material are brought in proximity with respect to each other. When the magnetic object 110 generating the magnetic field and the ferromagnetic material are moved away from each other, the ferromagnetic material can return to a neutral magnetic state. Any residual magnetization of the ferromagnetic material may be so small as to be negligible. Thus, in case the modification element 164 comprising the ferromagnetic material and the magnetic object 110 are brought in proximity to each other, the modification element 164 may create (or generate) an additional magnetic field due to the magnetization. The additional magnetic field may affect the magnetic field (more specifically on the magnetic field strength and/or the magnetic field form) of the magnetic object 110, which may be detectable with the plurality of magnetometers 300. Ferromagnetic materials can be used that are easily magnetizable but can also easily lose their magnetization, e.g. soft magnetic materials. These include, for example, soft iron and a number of alloys such as Mu-Metal. The diamagnetic material may be weakly magnetized in a direction opposite the direction of the magnetic field induced, i.e., the magnetic field 115 created by the magnetic object 110. The diamagnetic material may locally attenuate the magnetic field 115 created by the magnetic object 110 when brought in proximity to the magnetic object 110, which may be detected based on magnetic field measurements with the plurality of magnetometers 300. The paramagnetic material may be weakly magnetized in the direction of the magnetic field induced, i.e., the magnetic field 115 created by the magnetic object 110. The paramagnetic material may locally enhance the magnetic field 115 created by the magnetic object 110 when brought in proximity to the magnetic object 110, which may be detected based on magnetic field measurements with the plurality of magnetometers 300.

In some embodiments as shown in Figs. 5A to 7D, the modification element 164 may comprise a shielding element configured to at least partially shield the magnetic field of the magnetic object 110 with respect to an environment outside of the housing 101, more specifically depending on the location of the shielding element relative to the magnetic object 110. The shielding element may be used to modify the magnetic field strength and/or magnetic field form of the magnetic object. In embodiments, the magnetic field strength of the magnetic field created by the magnetic object 110 may be attenuated or enhanced. In other words, an intensity of the magnetic field of the magnetic object 110 as detected by the plurality of magnetometers 300 may be attenuated or enhanced. In some embodiments, the magnetic field may be deformed, e.g., such that the magnetic field may be no longer symmetric.

In embodiments, the shielding element 164 may be a sleeve configured to at least partially receive the magnetic object 110. The sleeve may be configured to at least partially cover the magnetic object 110. In some embodiments as shown in Figs. 5A and 7A, in the first state, the magnetic object 110 may be in a covered location, wherein the magnetic object 110 is at least partially covered by the shielding element 164 with respect to the environment of the housing 101. In the second state as shown in Figs. 5B and 7B, the magnetic object 110 may be in an exposed location, wherein the magnetic object 110 is exposed with respect to the environment of the housing 101. In other words, in the second state the magnetic object 110 may be (fully) exposed to the environment of the housing 101 and/or not covered by the shielding element 164. "Covered" means that the magnetic object 110 may be at least partially encircled by the shielding element 164 and/or the shielding element may shield a surface of the magnetic object with respect to the environment. In some embodiments, the covered location may be the first location and the exposed location may be the second location. In some embodiments, in the covered location, at least a predominant portion of the magnetic object 110 along its length and/or its circumference may be encircled or shielded by the shielding element. The at least one contact manipulation feature 170 may be coupled to one of the magnetic object 110 and the shielding element 164 via the transmission device 160 such that an actuation of the at least one contact manipulation feature 170 may cause a translation and/or rotation of the magnetic object 110 from the covered location to the exposed location. The magnetic object 110 may be configured to create the first magnetic field in the covered location. The magnetic object 110 may be configured to create the second magnetic field in the exposed location. The magnetic object 110 may be in the covered location when the at least one contact manipulation feature 170 is distanced to the interaction surface 210. The magnetic object 110 may be in the exposed location, when the at least one contact manipulation feature 170 and/or device contact surface 130 is in contact with the interaction surface 210. Of course, in embodiments, the at least one contact manipulation feature 170 may be actuated by a user instead of being actuated by contacting the interaction surface 210. As shown in Figs. 5A, 5B, 7A and 7B, the transmission device 160 may comprise the at least one biasing mechanism 161, which may be configured to urge the magnetic object 110 and/or the shielding element 164 to the covered location, when the at least one manipulation feature 170 is distanced to the interaction surface 110 or not actuated by a user U.

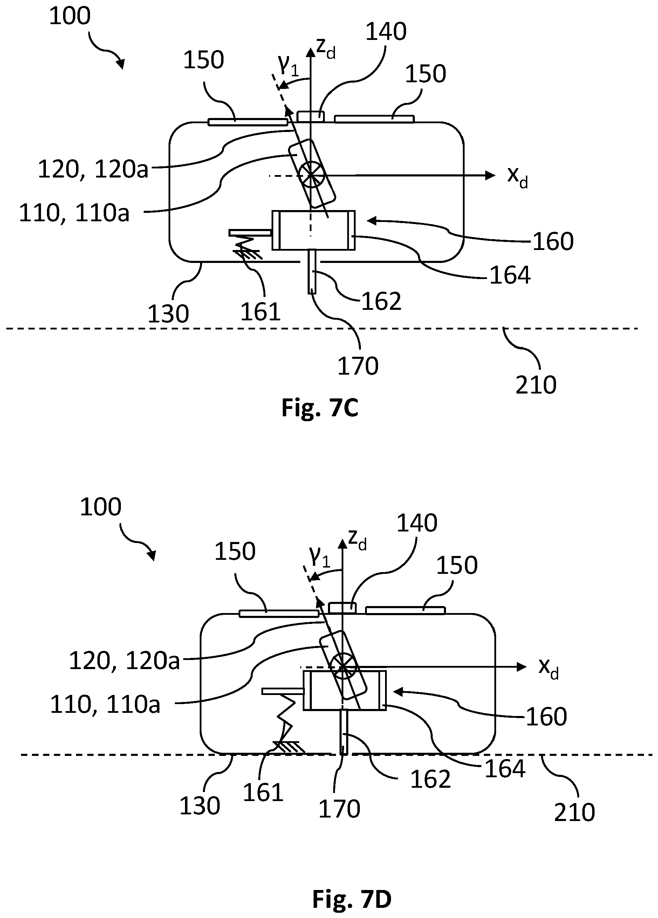

In some embodiments as shown in Figs. 6A and 7C, the above features may also apply - however, the covered location and exposed location may be the other way around with respect to the first state and the second state. In the first state, the magnetic object 110 may be in an exposed location, wherein the magnetic object 110 may be exposed with respect to the environment of the housing 101. In the second state as shown in Figs. 6B and 7D, the magnetic object 110 may be in a covered location, wherein the magnetic object 110 may be at least partially covered by the shielding element 164 with respect to the environment of the housing 101. In other words, in the first state the magnetic object 110 may be (fully) exposed to the environment of the housing 101 and/or not covered by the shielding element 164. The at least one contact manipulation feature 170 may be coupled to one of the magnetic object 110 and the shielding element 164 via the transmission device 160 such that an actuation of the at least one contact manipulation feature 170 may cause a translation and/or rotation of the magnetic object 110 from the exposed location to the covered location. The magnetic object 110 may be in the exposed location when the at least one contact manipulation feature 170 is distanced to the interaction surface 210. The magnetic object 110 may be in the covered location, when the at least one contact manipulation feature 170 and/or device contact surface 130 is in contact with the interaction surface 210. The transmission device 160 may comprise at least one biasing mechanism 161, which may be configured to urge the magnetic object 110 and/or the shielding element 164 to the exposed location, when the at least one manipulation feature 170 is distanced to the interaction surface 110 or not actuated by a user U.

In embodiments, the first magnetic field form may be substantially symmetric, more specifically rotationally symmetric. The second magnetic field form may be asymmetric. It should be noted that in some embodiments the transition may comprise both a location change and a magnetic field change, e.g., as indicated in Figs. 2A, 2B, 3A, 3B, 5A, 5B, 8A, 8B, 9A and 9B.

Referring to Figs. 9A and 9B, an embodiment of a user-borne device 100 according to the present disclosure is shown. In this embodiment, the user-borne device 100 may be a writing device, more specifically a stylus or a pen. In these embodiments, the housing 101 may be substantially cylindrical and may comprise a housing tip. The housing tip may comprise a nib configured to be operated on the interaction surface 210. The nib may protrude through the opening 102 provided in the housing tip and may be movable relative to the housing 101. In this embodiment, the nib may be the at least one contact manipulation feature 170 or may be coupled to the at least one contact manipulation feature 170 such that an actuation (e.g., a translation) of the nib may cause an actuation (e.g., a translation and/or rotation) of the at least one contact manipulation feature 170. The at least one contact manipulation feature 170 may be coupled with the magnetic object 110 via the transmission device 160 as described above. The nib may define the device contact surface or point 130. An actuation of the nib, more specifically a translation of the nib into the housing 101 due to a force applied on the nib (e.g., by a physical contact of the nib with the interaction surface 210), may cause a translation of the magnetic object 110 towards the interaction surface 210, more specifically towards the device contact surface or point 130. In the first state (i.e., in the default location), the nib may protrude out of the housing 101, more specifically through the opening 102, by a first protruding distance 11. In the second state (i.e., in the contact location), the nib may protrude out of the housing 101, more specifically through the opening 102, by a second protruding distance 12, which may be smaller than the first protruding distance 11. Thus, from the first state to the second state, the nib may move from the default location to the contact location. Due to the actuation of the nib, the magnetic object 110 may be moved from the first location to the second location, as indicated by the arrows in Fig. 9B. Thus, the transition may comprise the location change of the magnetic object 110. The location change may be detectable with the plurality of magnetometers 300 and may be indicative of the contact event. In some embodiments, the modification element 164 may be provided and fixedly coupled to the nib (i.e., the at least one contact manipulation feature 170 as shown in Figs. 9A and 9B). The transition may also comprise the magnetic field change as described above as the modification element 164 may be configured to change the magnetic field created by the magnetic object 110 depending on a location of the modification element 164 relative to the magnetic object 110. More specifically, in the first state and the default location of the nib, the distance between the modification element 164 and the magnetic object 110 may be larger than in the second state. Thus, the magnetic object 110 may have a first magnetic field in the first state and a second magnetic field in the second state. Due to the arrangement of the nib (more specifically the at least one contact manipulation feature 170) relative to the magnetic object 110, the location of the magnetic object relative to the device contact surface or point 130 and the location of the modification element 164 relative to the magnetic object 110 may change. Such an arrangement of the contact manipulation feature 170 relative to the magnetic object and provided via the arrangement of the transmission device 160 may be applicable to all embodiments described herein. Thus, the transition may comprise a location change and a magnetic field change, which may lead to increased accuracy and reliability for detecting and determining the contact event. As shown in Figs. 9A and 9B, the at least one biasing mechanism 161 may be coupled to the first lever member 161 and the housing 101, and may be configured to urge the nib to the default location when the nib is distanced to the interaction surface 210.

Additionally or alternatively to the described contact event, the transition from the first state to the second state may be indicative of a pressure event of the user-borne device 100. The pressure event may be indicative of a pressure applied to the at least one contact manipulation feature 170. The pressure event may be determined and/or analyzed based on the detected transition. In examples, the transition can be used to determine the magnitude of the pressure (e.g., over time) applied on the at least one contact manipulation feature 170. The pressure event may cause an action and/or may be used to control an action in the digital environment, more specifically the virtual environment. The pressure event may implement a user input or a physical contact of the at least one contact manipulation feature 170 with the interaction surface 210. In an example, the pressure event may be related to the movement of the magnetic object 110 as described above. Referring to the embodiment of Figs. 9A and 9B, the pressure event may be determined based on the pressure applied on the nib (i.e., based on the contact of the nib with the interaction surface 210).

### Click and/or scroll manipulation features

As indicated in Figs. 1, 7A to 8B and 10A to 13B, the user-borne device 100 may comprise at least one scroll manipulation feature 140 and/or at least one click manipulation feature 150, 150a, 150b. It should be noted that the below embodiments are explained with respect to the magnetic object 110. However, additional magnetic objects may be provided and the least one scroll manipulation feature 140 and/or at least one click manipulation feature 150 may be additionally or alternatively coupled to the additional magnetic objects.

The at least one click manipulation feature 150 and/or the at least one scroll manipulation feature 140 may be movably coupled to the housing 101 and actuatable by a user U. The at least one scroll manipulation feature 140 and/or at least one click manipulation feature 150 may be translatable and/or rotatable with respect to the housing 101. The magnetic object 110 may be coupled to the at least one scroll manipulation feature 140 and/or at least one click manipulation feature 150. More specifically, the magnetic object 110 may be operationally, e.g., mechanically, coupled to at least one scroll manipulation feature 140 and/or at least one click manipulation feature 150. A translation and/or rotation of the at least one scroll manipulation feature 140 and/or at least one click manipulation feature 150 relative to the housing 101 may cause a translation and/or a rotation of the magnetic object 110 relative to the housing 101. The at least one scroll manipulation feature 140 and/or at least one click manipulation feature 150 may be actuated by a user U. In an initial state of the user-borne device 100, the at least one scroll manipulation feature 140 and/or at least one click manipulation feature 150 and/or the magnetic object 110 may be in an initial location. In an actuated state of the user-borne device 100, the at least one scroll manipulation feature 140 and/or at least one click manipulation feature 150 and/or the magnetic object 110 may be in the actuated location. In other words, in case the at least one scroll manipulation feature 140 and/or at least one click manipulation feature 150 is not actuated by user U, the user-borne device 100 may be in the initial state. In case the at least one scroll manipulation feature 140 and/or at least one click manipulation feature 150 is actuated by user U, the user-borne device 100 may be in the actuated state. More specifically, in the actuated state, the at least one scroll manipulation feature 140 and/or at least one click manipulation feature 150 and/or the magnetic object 110 may be in the actuated location, more specifically wherein (or when) the at least one scroll manipulation feature 140 and/or at least one click manipulation feature 150 are actuated by a user U. An actuation of the at least one click manipulation feature 150 and/or at least one scroll manipulation feature 140 may cause a rotation and/or translation of the magnetic object 110 with respect to the housing 101 from the initial location to the actuated location.

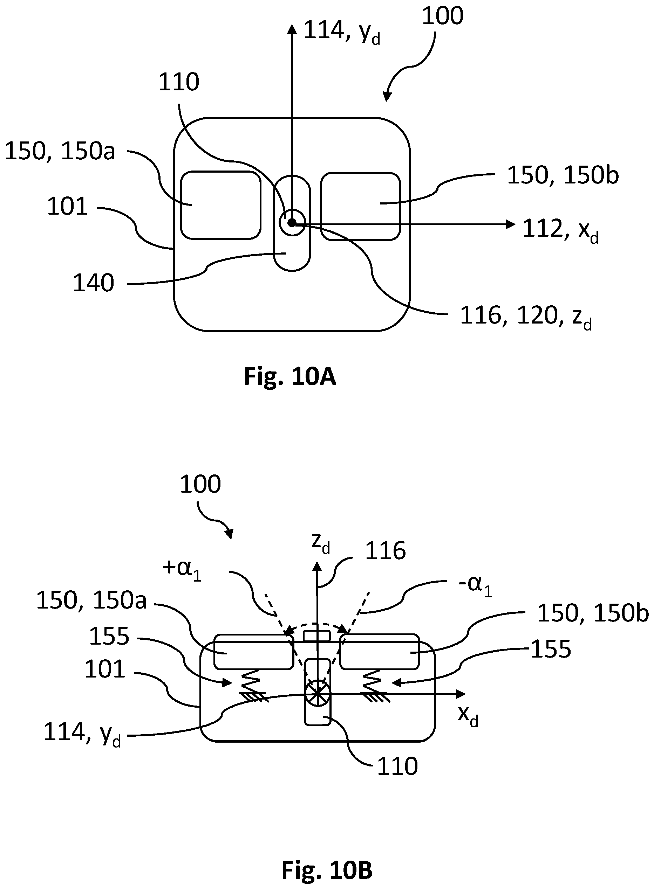

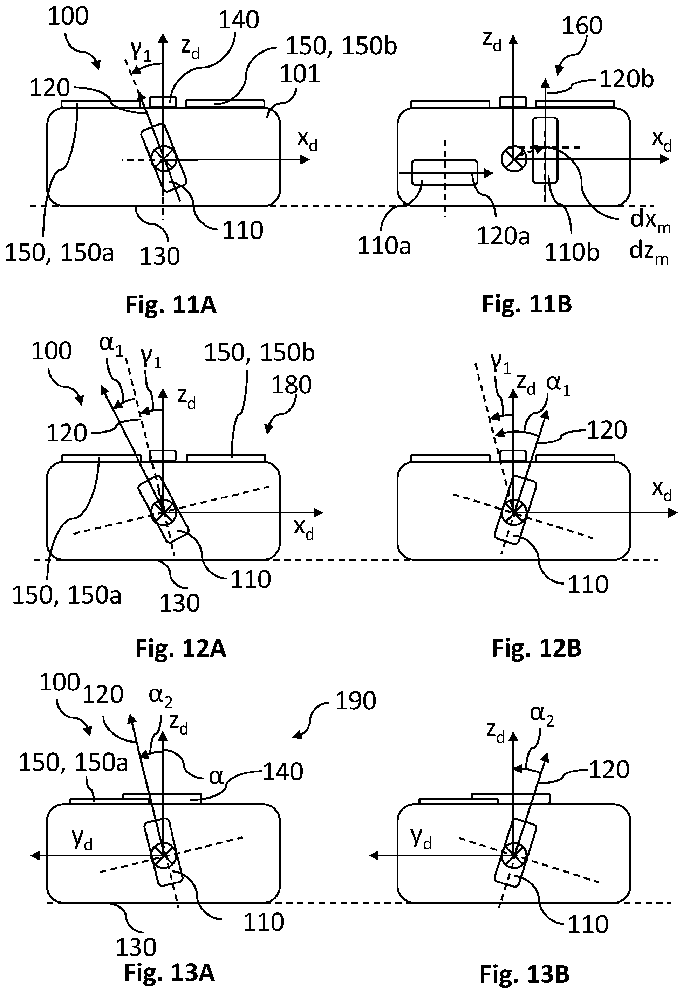

Referring to the examples shown in Figs. 10A, 10B, 11A, 12A and 12B, an actuation of the at least one scroll manipulation feature 140 and/or at least one click manipulation feature 150 may lead to a first rotation 180 about the second device axis y_{d} as described above. Depending on a direction of an actuation of the at least one scroll manipulation feature 140 and/or at least one click manipulation feature 150, a first rotation angle α₁ may have a positive value or a negative value. In embodiments, referring to Figs. 13A and 13B, an actuation of the at least one scroll manipulation feature 140 and/or at least one click manipulation feature 150 may lead to the second rotation 190 about the first device axis x_{d} as described above. Depending on a direction of an actuation of the at least one scroll manipulation feature 140 and/or at least one click manipulation feature 150, a second rotation angle α₂ may have a positive value or a negative value. Referring to Fig. 11B, an actuation of the at least one scroll manipulation feature 140 and/or at least one click manipulation feature 150 may lead to a translation 160 of the magnetic object 110 along the first device axis x_{d}, the second device axis y_{d}, and/or the vertical device axis z_{d}. In the initial state of the user-borne device 100, an orientation of the magnetic object 110 relative to the housing 101 may be defined based on a set of inclination angles γ₁, γ_{2,} γ₃. More specifically, the set of inclination angles γ₁, γ_{2,} γ₃ may be measured between the magnetic moment vector 120 and the respective axes of the device coordinate system. In an example as shown in Fig. 12A and 12B, γ₁ may be measured between the vertical device axis z_{d} and the magnetic moment vector 120. In an initial state of the user-borne device 100, the magnetic moment vector 120 may be inclined by inclination angle γ₁ with respect to the vertical device axis z_{d}.

The at least one biasing mechanism 161 as described above may be at least one first biasing mechanism. Referring to Fig. 10B, the user-borne device 100 may comprise at least one third biasing mechanism 155. In some embodiments, the at least one first biasing mechanism and the at least one third biasing mechanism 155 may be the same biasing mechanism. The at least one third biasing mechanism 155 may be configured to urge the at least one scroll manipulation feature 140 and/or at least one click manipulation feature 150 and/or magnetic object 110 from the actuated location to the initial location, more specifically when the at least one scroll manipulation feature 140 and/or at least one click manipulation feature 150 is not actuated. More specifically, when a user actuates (e.g., applies a force on) the at least one scroll manipulation feature 140 and/or at least one click manipulation feature 150, the at least one scroll manipulation feature 140 and/or at least one click manipulation feature 150 and magnetic object 110 may be moved from the initial location to the actuated location. In this case, the at least one third biasing mechanism 155 may be biased. When a user releases the force on the at least one scroll manipulation feature 140 and/or at least one click manipulation feature 150, the at least one scroll manipulation feature 140 and/or at least one click manipulation feature 150 and the magnetic object 110 may be urged from the actuated location to the initial location.

The at least one scroll manipulation feature 140 and/or at least one click manipulation feature 150 may be associated with at least one interaction trigger event. The system 10 and/or the electronics device 500 may be configured to determine the respective interaction trigger event based on a translation and/or rotation of the magnetic object 110 relative to the user-borne device 100 as described above, more specifically caused by a translation and/or rotation of the least one scroll manipulation feature 140 and/or at least one click manipulation feature 150 being operationally coupled to the magnetic object 110. In particular, an electronics device 500 and/or the system 10 may be configured to determine a position and/or rotation deviation between the initial location and the actuated location. In other words, a specific translation and/or rotation of the magnetic object 110 relative to the at least one user-borne device 100 may be detectable by the system 10, more specifically by the electronics device 500. Based on the detected specific translation and/or rotation, the system 10 and/or the electronics device 500 may be configured to transform this movement to at least one trigger event associated with the translation and/or rotation. In an example, the system 10 and/or the electronics device 500 may be coupled to (and/or include) a database. The database may comprise data associating at least one interaction trigger event with a specific translation and/or rotation of the magnetic object 110 from the initial location to the actuated location. The system 10 and/or the electronics device 500 may be configured to transmit to and/or receive data from the database. In the embodiments shown in Figs. 10B, 12A and 12B, the first rotation 180 may be associated with a first trigger event. In the embodiments shown in Figs. 13A and 13B, the second rotation 190 may be associated with a second trigger event. The respective trigger event may be, e.g., a click event, a scroll event, a keyboard event (e.g., in case the user-borne device 100 may be or comprise a keyboard) and/or a selection event. In case a plurality of magnetic objects is provided, additional trigger events may be determined based on a rotation and/or translation of the magnetic objects relative to each other and detectable by the system 10 and/or the electronics device 500. The at least one interaction trigger event may be initiated by a user manipulation of the at least one user-borne device 100, more specifically the at least one electrically and/or electronically passive user-borne device 100, within the sensing volume M. The at least one interaction trigger event may cause an action and/or may be used to control an action in a digital environment (i.e., an environment which is controlled by a computer or a network of computers), e.g., a virtual environment, based on a user input. More specifically, the at least one interaction trigger event may implement a user input on the at least one user-borne device 100 as an action in the digital environment. For instance, the at least one user-borne device 100 may be used together with the electronics device 500 which may be or may comprise e.g., a tablet, a cell phone, a smartphone, a laptop, a computer, a virtual reality (VR) set, a notebook, a foldable smartphone, a foldable tablet, an electronics device sleeve and/or a television. The at least one interaction trigger event may cause an action on the electronics device 500 and/or may be used to control an action on the electronics device 500 based on a user input on the at least one user-borne device 100.

As mentioned above, the at least one interaction trigger event may be a scroll event and/or a click event. A scroll event and/or a click event may be applied to various different application fields. A scroll event may trigger a scroll action in a digital environment, more specifically a virtual environment, based on a user input, e.g., "scroll up" and "scroll down" on a display. A scroll event may cause or provide a control of a rotational and/or translational movement of a virtual object in a digital environment, more specifically a virtual environment, that is associated with a user input. For instance, a scroll event may trigger a scroll action including scrolling of files or data, a rotational or translational movement of the virtual object associated with a selection of a choice from a plurality of choices. The scroll action may also include rotating a body in a virtual environment and/or changing a perspective in a virtual environment. Furthermore, a scroll action may include one or more of moving a cursor in two opposing directions (e.g., horizontal or vertical on an output device), moving a displayed element (e.g. a page, a cursor), which may be controlled by the at least one user-borne device 100, a step in a direction, flipping through a menu, flipping through a selection list, or adjusting (e.g. increasing or decreasing) a parameter (e.g. a setting or a configuration). A click event may trigger a click action (more specifically of a virtual object) in a digital environment, more specifically a virtual environment, based on a user input. A click event may include, e.g., a selection of an object (like a button, a file, an icon or another object), a selection of an item, a selection of a list, a selection of an item on a list. A click event may trigger a following action. A click event may trigger an action that provides additional information and/or properties of an object, an item or a text (e.g., letter, word, phrase) selected. A click event may trigger a single click action, a double click action, a triple click action, a right click action and/or a click-and-drag action within a digital environment, more specifically a virtual environment. A single click action may refer to selection of an object within a virtual environment. A double click action may open a file or execute a program within a virtual environment. A click-and-drag action may include clicking, holding and moving an object, e.g., which may be used to highlight or drag-select a text or an object. A triple click action may be used to select a paragraph of a text. A right click action may perform a special action, e.g., opening a list with additional information and/or properties for a selected object as mentioned above. The action that is triggered by the click event depends on the user's input on the at least one user-borne device 100. For example, the click event may cause a double-click action when a user provides two quick and successive inputs on the at least one user-borne device 100. The above-mentioned features enable various new application fields for the at least one user-borne device 100, for example a computer-mouse, a stylus, a keyboard, a dial, a mouse scroll element (e.g., a wheel), a joystick, a control for an electronic device (e.g. an audio control or a visual control), a control of software settings or visualizations (e.g. graphic software or design software), or a control of a computer game.

In the embodiments as shown in Figs. 1, 7A to 8B and 10A to 13B, the user-borne device 100 may comprise a first click manipulation feature 150a, at least one second click manipulation feature 150b and at least one scroll manipulation feature 140. Each of the first click manipulation feature 150a, the at least one second click manipulation feature 150b and the at least one scroll manipulation feature 140 may be operationally coupled to the magnetic object 110 or may be coupled to additional, different magnetic objects. In this example, the user-borne device 100 may be, e.g., a computer mouse. Actuating the first click manipulation feature 150a or the at least one second click manipulation feature 150b may lead to the first rotation 180 of the magnetic object 110. Depending on the direction of the actuation, the first rotation angle α₁ may comprise a positive value or a negative value. The system 10 and/or the electronics device 500 may be configured to detect the first rotation angle α₁ and may transform this rotation into a click event comprising a first click event or a second click event, depending on the first rotation angle value. The first click event may trigger a left click action more specifically a single click action, a double click action, a triple click action, and/or a click-and-drag action as described above. The second click event may trigger the right click action as described above. Actuating the at least one scroll manipulation feature 140 may lead to the second rotation 190 of the magnetic object 110. Depending on the actuation, the second rotation angle α₂ may comprise a positive value or a negative value. The system 10 and/or the electronics device 500 may be configured to detect the second rotation angle α₂ and may transform this rotation into a scroll event. The scroll event may comprise a first scroll event or a second scroll event. The respective scroll event may depend on the second rotation angle value. More specifically, the first rotation 180 may be associated with a click event. In case the first rotation angle α₁ has a positive value, this may be associated with a first click event. In case the first rotation angle α₁ has a negative value, this may be associated with a second click event. The second rotation 190 may be associated with a scroll event. In case the second rotation angle α₂ has a positive value, this may be associated with a first scroll event (e.g.. a "scroll up"). In case the second rotation angle α₂ has a negative value, this may be associated with a second scroll event (e.g., a "scroll down").

### Combination of click, scroll and contact manipulation feature on the same magnetic object

In the following, embodiments of the at least one contact manipulation feature 170 and the at least one scroll manipulation feature 140 and/or at least one click manipulation feature 150 will be described in more detail.

In some embodiments, the at least one click manipulation feature 150, the at least one scroll manipulation feature 140 and/or the at least one contact manipulation feature 170 may be configured to interact with the magnetic object 110 such that an actuation of the at least one click manipulation feature 150, the at least one scroll manipulation feature 140 and/or the at least one contact manipulation feature 170 cause the transition of the magnetic object 110 from the first state to the second state. The magnetic object 110 may be operatively coupled to the at least one click manipulation feature 150 and/or to the at least one scroll manipulation feature 140 such that an actuation of the at least one click manipulation feature 150 and/or at least one scroll manipulation feature 140 may cause a rotation and/or translation of the magnetic object 110 with respect to the housing 101. Based on an actuation of the at least one click manipulation feature 150 and/or at least one scroll manipulation feature 140, the magnetic object 110 may be transitioned from the first state to the second state. The transition may comprise the features as described above for the at least one contact manipulation feature 170. The at least one click manipulation feature 150 and/or to the at least one scroll manipulation feature 140 and the at least one contact manipulation feature 170 may be coupled to the magnetic object 110 (more specifically, to the same magnetic object 110). The user-borne device 100 may be configured to control at least one trigger event based on the rotation and/or translation of the magnetic object 110 caused by an actuation of the at least one click manipulation feature 150 and/or at least one scroll manipulation feature 140. As mentioned above, the user-borne device 100 may be configured to control a contact event detectable with a plurality of magnetometers 300 based on the transition caused by the actuation of the at least one contact manipulation feature 170, more specifically wherein the trigger event may be detectable only in response to a detected contact event.

### Multiple magnetic objects

In some embodiments as shown, e.g., in Figs. 8A and 8B, the magnetic object 110 may be a first magnetic object 110a and the user-borne device 100 may comprise at least one second magnetic object 110b. The first magnetic object 110a and the at least one second magnetic object 110b may be arranged distanced to each other. The distance between the first magnetic object 110a and the at least one second magnetic object 110b may be large enough such that the plurality of magnetometers 300 may identify them as two separate magnetic objects. The at least one second magnetic object 110b may comprise the features as described above for the magnetic object 110. The at least one second magnetic object 110b may be arranged within the housing 101.

The at least one contact manipulation feature 170 may be mechanically coupled to the first magnetic object 110a via the transmission device 160 such that an actuation of the at least one contact manipulation feature 170 may cause a translation and/or rotation of the first magnetic object 110a from the first location to the second location. During transition from the first location to the second location, the first magnetic object 110a may be translated towards or away from and/or rotated relative to the at least one second magnetic object 110b. The at least one second magnetic object 110b may be arranged translatable and/or rotatable with respect to the housing 101, or, the at least one second magnetic object 110b may be fixedly coupled to the housing 101.

In the embodiments as shown, e.g., in Figs. 8A and 8B, the first magnetic object 110a may be operatively coupled to the at least one contact manipulation feature 170. The at least one second magnetic object 110b may be operatively coupled to the at least one click manipulation feature 150 and/or to the at least one scroll manipulation feature 140 such that an actuation of the at least one click manipulation feature 150 and/or at least one scroll manipulation feature 140 may cause a rotation and/or translation of the at least one second magnetic object 110b with respect to the housing 101, more specifically wherein the at least one second magnetic object 110b is in an actuated state. In this case, the at least one second magnetic object 110b may be arranged translatable and/or rotatable with respect to the housing 101. In some embodiments (not shown), the user-borne device 100 may comprise a first magnetic object 110a operatively coupled with the at least one contact manipulation feature 170, a second magnetic object operatively coupled with the at least one click manipulation feature 150, and at least one third magnetic object operatively coupled with the at least one scroll manipulation feature 140. In some embodiments, the user-borne device 100 may comprise at least one fourth magnetic object fixedly coupled to the housing. The at least one fourth magnetic object may be used for improved location determination. In some embodiments, one magnetic object per contact manipulation feature, scroll manipulation feature and click manipulation feature may be provided.

Referring to Figs. 8A and 8B, the first magnetic object 110a may comprise a first magnetic moment vector 120a and/or a first magnetic object position vector, and the at least one second magnetic object 110b may comprise a second magnetic moment vector 120b and/or a second magnetic object position vector. The first magnetic object 110a and the at least one second magnetic object 110b may be arranged within the housing, such that the first magnetic object 110a and the at least one second magnetic object 110b may rotate relative to each other based on an actuation of the at least one contact manipulation feature 170, the at least one scroll manipulation feature 140 and/or the at least one click manipulation feature 150. The rotation of the first magnetic object 110a and the at least one second magnetic object 110b relative to each other may be detectable based on magnetic field measurements with the plurality of magnetometers 300. More specifically, the orientation of the first magnetic moment vector 120a and the at least one second magnetic moment vector 120b relative to each other may be determined. Based on the rotation of the first magnetic moment vector 120a relative to the at least one second magnetic moment vector 120b, the contact event and/or the trigger event may be determined. In some embodiment (not shown), the first magnetic object 110a and the at least one second magnetic object 110b are arranged in the housing 101, such that, in the first state (i.e., the contact manipulation feature is not actuated) and the initial state (i.e., the at least one scroll manipulation feature 140 and/or the at least one click manipulation feature 150 are not actuated), the first magnetic moment vector 120a may be substantially parallel to the second magnetic moment vector 120b. However, as shown in Figs. 8A, in some embodiments, in the first state and the initial state, the first magnetic object 110a may be arranged in the housing 101, such that the first magnetic moment vector 120a may be substantially parallel to the vertical device axis z_{d}. The first magnetic moment vector 120a and/or the second magnetic moment vector 120b may be oriented such that a rotation of the first magnetic object 110a and/or the second magnetic object 110b about a first rotation axis 112 and at least one second rotation axis 114 may be detectable based on magnetic field measurements with a plurality of magnetometers 300.

The user-borne device 100 as described above may comprise a tactile and/or audible feedback device (not shown in the Figs.). The tactile and/or audible feedback device may be configured to provide a tactile and/or audible feedback to a user U based on a control of a contact event and/or at least one trigger event. More specifically, the tactile and/or audible feedback device may provide a tactile and/or audible feedback to a user U based on an actuation of the at least on contact manipulation feature 170, the at least one click manipulation feature 150 and/or the at least one scroll manipulation feature 140.

### System

Fig. 1 schematically illustrates a system 10 for determining a manipulation of a user-borne device 100 according to a second aspect of the present disclosure. The manipulation of the user-borne device 100 may be provided by a contact, more specifically a physical contact of the user-borne device with the interaction surface, or by a user U. The system 10 comprises a user-borne device 100 according to the first aspect of the present disclosure. The user-borne device 10 may comprise any of the above-described embodiments and/or features. The 10 system comprises a plurality of magnetometers 300. The plurality of magnetometers 300 is configured to measure the magnetic field created or generated by the magnetic object 110. The system is configured to detect a transition of the magnetic object 110 from a first state to a second state. Furthermore, the system 10 is configured to determine a contact event of the user-borne device 100 with the interaction surface 210 based on the detected transition. The transition from the first state to the second state, the contact event and the associated features are already explained above.

The system 10 may allow the tracking and/or location determination of a user-borne device 100, more specifically an electronically and/or electrically user-borne device 100, in at least five degrees of freedom. The plurality of magnetometers 300 may be configured to create a sensing volume M (as indicated, e.g., in Fig. 1). The sensing volume may have an ellipsoidal form. The plurality of magnetometers 300 may be associated with a magnetometer plane 310.

More specifically, the magnetometer plane 310 may be defined by a plane that may extend through a majority of the plurality of magnetometers 300. In some embodiments, the user-borne device 100 may be operable on the interaction surface 210, more specifically wherein the interaction surface 210 may be defined within the sensing volume M.

As indicated, e.g., in Fig. 1, the system 10 may comprise a reference coordinate system XYZ, which may be defined relative to the plurality of magnetometers 300. The reference coordinate system XYZ may comprise a first reference axis X, a second reference axis Y and a vertical reference axis Z. The first reference axis X and the second reference axis Y may be orthogonal with respect to each other. The vertical reference axis Z may be orthogonal to the first reference axis X and the second reference axis Y. The vertical reference axis Z may extend through a center of the plurality of magnetometers 300. In embodiments, the first reference axis X and the second reference axis Y may be defined on the magnetometer plane 310. The vertical reference axis Z may be orthogonal to the magnetometer plane 310.

As outlined above, the plurality of magnetometers 300 may be configured to measure the magnetic field 115 generated or created by the magnetic object 110. Each magnetometer of the plurality of magnetometers 300 may be configured to measure the magnetic field created by the magnetic object 110 in the direction of the first reference axis X, the second reference axis Y, and/or the vertical reference axis Z. In other words, each magnetometer of the plurality of magnetometers 300 may be configured to perform magnetic field measurements in the direction of one axis (i.e., one dimension), two axes (i.e., two dimensions), or three axes (i.e., three dimensions). The number of magnetometers provided may depend on the size of the interaction surface 210, on which the user-borne device 100 is operated, or, on the desired size of the sensing volume M within which the user-borne device 100 is operated. The plurality of magnetometers 300 may be configured to collect magnetic field measurements associated with the magnetic object 110 within the sensing volume M up to a maximum measurement distance, wherein the maximum measurement distance may be a distance within which the magnetic field measurements can be provided with acceptable reliability and/or accuracy. In embodiments, the maximum measurement distance may be 18cm, more specifically 15cm. During a user operation, the magnetic object 110 and the interaction surface 210 may within the maximum measurement distance. In other words, the minimum magnet field generated by a magnetic object 110 that may be tracked with the system may comprise at least 1 micro tesla.

The plurality of magnetometers 300 may be fixedly arranged in a magnetometer body 320 (see, e.g., Fig. 9A) defining a fixed position and/or orientation of the plurality of magnetometers 300 with respect to each other. The magnetometer plane 310 may be defined by a plane that extends through a majority of the plurality of magnetometers 300. More specifically, the magnetometer plane 310 may extend through centers, more specifically geometric centers, of a majority of the plurality of magnetometers 300. In other words, most of the magnetometers of the plurality of magnetometers 300 may be arranged in a common plane, i.e., the magnetometer plane 310. However, one or more magnetometers of the plurality of magnetometers 300 may be distanced and/or inclined with respect to the common plane, e.g., due to manufacturing issues and/or tolerances. The magnetometer plane 310 may additionally or alternatively be defined by a plane in which the magnetometers of the plurality of magnetometers 300 are predominantly arranged.

Referring to Fig. 14, an arrangement of the plurality of magnetometers 300 with respect to the interaction surface 210 defined on an interaction support 200 is shown. In the embodiment shown in Fig. 13, the plurality of magnetometers 300 may be arranged in rows and columns. However, it is also possible that the plurality of magnetometers may be arranged in an unordered manner within the magnetometer body 320. A calibration procedure may be used to determine the exact locations, measurement axes, sensitivity and/or offset of each magnetometer within the magnetometer body 320 relative to the reference coordinate system XYZ. The plurality of magnetometers 300 are shown in Fig. 14 as being arranged in the magnetometer plane 310 (i.e., in the same plane relative to the vertical reference axis Z). However, as outlined above, one or more of the magnetometers may be distanced to the magnetometer plane 310, more specifically distanced in the direction of the vertical reference axis Z.

In the arrangement of Fig. 14, the plurality of magnetometers 300 may be arranged in the magnetometer body 320 in rows k und columns 1. Fig. 14 illustrates some magnetometers S_{k,l} of the plurality of magnetometers 300. Each magnetometer S_{k,l} may comprise a vertical magnetometer axis z_{M} which may be arranged on the intersections of the rows k and columns 1. Adjacent magnetometers S_{k,l}, S_{k,l+1}, S_{k,l-1} may be separated along a row k by a distance d_{l,l+1} and d_{l,l-1}. Adjacent magnetometers S_{k,l}, S_{k+1,l}, S_{k-1,l} may be separated along a column 1 by a distance d_{k,k+1} and d_{k,k-1}. As outlined above, the distances dₖ, dₗ between the respective magnetometers S_{k,l} may be equal or may differ.

As indicated in Figs. 1, 10A and 12, the system 10 may further comprise or be connectable to a processing unit 400. The system 10, more specifically the processing unit 400, may be configured to track a movement of the magnetic object 110 and/or the user-borne device 100 in at least five degrees of freedom. The at least five degrees of freedom may include a translation of the magnetic object 110 along the first reference axis X, the second reference axis Y and the vertical reference axis Z, a rotation about the first rotation axis 112 and a rotation about the second rotation axis 114. In case the magnetic object 110 is configured to create an asymmetric magnetic field (i.e., which is not rotationally symmetric), a rotation about the third rotation axis 116 may be additionally detected. In this case the system 10 may be configured to track a movement of the magnetic object 110 and/or the user-borne device 100 in at least six degrees of freedom. In case the user-borne device 100 is operated on the interaction surface 210, the system 10 may be configured to determine the contact event between the user-borne device 100 and the interaction surface 210 based on the detected transition. In case the system 10 detects the contact event, it may derive the location of the interaction surface 210 with high accuracy and reliability. The location determination and/or tracking of the user-borne device 100 may be done relative to the interaction surface 210. This may be done based on a determined user-borne device location and the interaction surface location as described in the method below. During a user operation, the system 10 may be configured to track a movement of the user-borne device 100 within the sensing volume M and/or relative to the interaction surface 210 over a time period. More specifically the system 10 may be configured to determine a trajectory of the user-borne device 100 within the sensing volume M and/or relative to the interaction surface 210. In embodiments, the user-borne device 100 may be tracked over a time period comprising multiple time samples. At each time sample, the location of the user-borne device 100 within the sensing volume M and/or relative to the interaction surface 210 may be determined. The system 10, more specifically the processing unit 400 may be configured to detect the transition and to determine the contact event based on the detected transition. As mentioned above, the user-borne device 100 may be operable on the interaction surface 210 and the system 10 may be configured to determine a location of the user-borne device 100 within the sensing volume relative to the interaction surface 210 based on the magnetic field measurements. More specifically, the system may be configured to determine a movement of the user-borne device 100 on the interaction surface 210 based on the determined contact event and the determined location of the user-borne device 100.

The system 10, more specifically the processing unit 400, may be configured to determine the at least one trigger event as described above. The at least one trigger event may be determined based on a control of the user-borne device 100 (e.g., a manipulation of the user-borne device by a user). In some embodiments, the user-borne device 100 may comprise the at least one click manipulation feature 150 and/or the at least one scroll manipulation feature 140 as described above, which may be movably coupled to the housing 101 and actuatable by a user U. In some embodiments, the at least one click manipulation feature 150, the at least one scroll manipulation feature 140 and/or the at least one contact manipulation feature 170 may be configured to interact with the magnetic object 110 such that an actuation of the at least one click manipulation feature 150, the at least one scroll manipulation feature 140 and/or the at least one contact manipulation feature 170 may cause the transition of the magnetic object 110 from the first state to the second state as described above. In embodiments, the magnetic object 110 may be operatively coupled to the at least one click manipulation feature 150 and/or to the at least one scroll manipulation feature 140 such that an actuation of the at least one click manipulation feature 150 and/or at least one scroll manipulation feature 140 may cause a rotation and/or translation of the magnetic object 110 with respect to the housing 101. The system 10 may be configured to determine the at least one trigger event based on the detected transition from the first state to the second state, or, based on a detected rotation and/or translation of the magnetic object 110 caused by an actuation of the at least one click manipulation feature 150 and/or at least one scroll manipulation feature 140. The same may apply to the embodiments, wherein a plurality of magnetic objects 110a, 110b are provided.

In some embodiments, the system 10 may be configured to determine the at least one trigger event only in response to a detected contact event. In other words, the at least one trigger event may not be determined as long as a contact event is not detected. The system 10 may be configured to determine the scroll event and/or the click event based on determining an actuation of the at least one scroll manipulation feature 140 and/or at least one click manipulation feature 150 by a user U, more specifically wherein the magnetic object 110 may be rotated about the first rotation axis 112 and the second rotation axis 114 (and additionally the third rotation axis 116 in case the magnetic object 110 is configured to create an asymmetric magnetic field).

Referring to Figs. 1 and 9A, the system 10 may comprise at least one output device 510. The at least one output device 510 may be configured to represent the user-borne device 100. More specifically, the at least one output device 510 may be configured to visually reproduce the user-borne device 100 as a virtual object. In the embodiment shown in Fig. 1, the system 10 may comprise one output device 510. In embodiments, the output device 510 may be a visual screen or display. The system 10 may be configured to reproduce a movement of the user-borne device 100 within the sensing volume M and/or on the interaction surface 210 as a movement of the virtual object on the at least one output device 510. Furthermore, the system 10 may be configured to visually reproduce the at least one trigger event on the output device 510. In some embodiments, the system 10 may be configured to represent, more specifically to visually reproduce, a determined contact event on the output device 510.

As described above, the magnetic field 115 created by the magnetic object 110 may comprise a magnetic field strength. In some embodiments, the system 10 may be configured to set a threshold for the magnetic field strength, and the system 10 may be configured to reject magnetic field measurements associated with a magnetic field strength that is equal to or less than the set threshold for the magnetic field strength. The magnetic field 115 may be defined by the magnetic field strength, a magnetic field location and/or a magnetic field direction. These parameters may be derived from the magnetometer measurements. In embodiments where the shielding element at least partially covers the magnetic object, magnetic field measurements with a magnetic field strength equal to or smaller than a threshold magnetic field strength may be rejected. When the magnetic object 110 is in the exposed position, the magnetic field strength may increase to a value being larger than the set magnetic field strength threshold. In this case, the system 10 may accept the magnetic field measurements. This may lead to increased accuracy and reliability for determining a contact event and/or the location of the user-borne device 100 relative to the interaction surface 210.

The system 10 may comprise an electronics device 500 as mentioned above. The at least one output device 510 may be integrated in the electronics device 500. In embodiments, the electronics device 500 may be a tablet, a cell phone, a laptop, a computer, a virtual reality (VR) set or a television. In embodiments, the processing unit 400 may be integrated in the electronics device 500. Furthermore, the electronics device 500 may comprise a user interface configured to interact with a user U and/or receive a user input. In an embodiment, the user interface may be integrated into the at least one output device 510. The plurality of magnetometers 300 may be configured to receive data from and/or transmit data to the processing unit 400. The system 10 may comprise a data storage connected to the processing unit 400. The data storage may comprise a primary data storage, e.g., a RAM, and a secondary data storage. The data storage may be integrated in and/or connected to the electronics device 500.

As indicated in Figs. 1 and 9A, the system 10 may comprise an interaction support 200 having an interaction support surface 230. The interaction surface 210 may be at least a partial surface of the interaction support surface 230. The interaction support 200 may not comprise ferromagnetic properties, e.g., ferromagnetic particles. In embodiments, the interaction support 200 may be a furniture (e.g., a table), a notebook, an electronics device 500, a screen, a wall, or a mouse pad. The interaction surface 210 may be defined based on a first set of geometric parameters associated with the interaction support 200. More specifically, the type of interaction support 200 may be known, e.g., a notebook or mouse pad. Such an interaction support 200 may be defined by a set of predefined geometric parameters. A partial surface of the interaction support surface 230 may be used as interaction surface 210.

As described above, the system 10 may be configured to determine and/or to track the user-borne device 100 relative to the interaction surface 210. This requires the definition of an interaction surface location and the user-borne device 100 may be operated on different interaction surfaces which may not be known by the system 10. This may be done based on a determined user-borne device location and the interaction surface location as described in the method below.

More specifically, when the system 10 determines a contact event, this may indicate that the user-borne device 100 may be in physical contact with the interaction surface 210. Thus, the system 10 may derive a plane of the interaction surface 210, e.g., due to the device contact surface 130 being in contact with the interaction surface 210. In some embodiments wherein the user-borne device 100 comprises a device contact point (e.g., Figs. 9A and 9B), the system 10 may determine multiple contact events from which the system 10 may derive multiple device contact points on the interaction surface 210. The system 10 may be configured to prompt a user U via the user interface to actuate the at least one contact manipulation feature 170 at multiple surface locations of the interaction surface 210 which are distanced to each other. The multiple surface locations may be stored and the system may derive a set of geometric parameters describing the interaction surface 210 with high accuracy and reliability. Based on the magnetic field measurements of the magnetic object 110 from which the magnetic object location may be determined relative to the device coordinate system and/or to the interaction surface 210.

The plurality of magnetometers 300 may be electrically (e.g., via wires or a data bus) or wirelessly connected to the processing unit 400, an external processing unit and/or to the electronics device 500. In embodiments, the plurality of magnetometers 300 may be integrated in a wall, a furniture, a notebook, an electronics device 500, a screen, a keyboard, and/or a mouse pad. In case the plurality of magnetometers 300 is arranged in a wall, the interaction surface 210 may be a screen or display placed in front of the plurality of magnetometers 300. In embodiments, the interaction surface 210 may be defined on the at least one output device 510.

As outlined above, the user-borne device 100 is configured to control at least one trigger event. More specifically, the at least one trigger event may cause an action and/or may be used to control an action in a digital environment, more specifically a virtual environment, based on a user input. In addition, the system 10 may determine the contact event, which may also cause an action and/or may be used to control an action in the digital (or virtual) environment. Furthermore, the user-borne device 100 according to the above aspects of the present disclosure may be reproduced as a virtual object in the virtual environment. The electronics device 500 may be a VR set, more specifically an XR headset which may be a device worn on a user's head and configured to allow a user to experience virtual environments in real life (virtual reality environment, or VR environment). In an embodiment, the user-borne device 100 may be reproduced as a virtual object in the VR environment allowing a user U to recognize where the user-borne device 100 is located. A plurality of magnetometers 300 may be provided creating a sensing volume M in which the user-borne device 100 is operated. The user-borne device location (see, e.g., as described above and/or with respect to the method below) may be indicative of an orientation and/or a position of the user borne device 100 relative to the reference coordinate system XYZ, more specifically to the plurality of magnetometers 300. The reference coordinate system XYZ may be fixed in the VR environment. A position and/or an orientation of the user-borne device 100 may be computed relative to the VR set, more specifically to the XR headset, and may be reproduced, particularly displayed, to the user via the XR headset. In some embodiments, the reference coordinate system XYZ may be dynamically evaluated from a tracking of the VR environment of the XR headset. In embodiments, it may be possible to provide an additional tracking system being fixed to the plurality of magnetometer 300 such as IR tracking, electromagnetic tracking or camera-based tracking. The at least one trigger event (e.g., the click event or scroll event) and the caused action may also be represented in the VR environment, more specifically which may be displayed to a user U via a display arranged in the XR headset. The representation in the VR environment may be done by changing a rendering parameter of the user-borne device 100, for instance color or light, and/or adding a specific sound. In some embodiments, the interaction surface 210 may be modeled in the VR environment, displayed to a user via the XR headset and/or used as an input to represent an interaction between the user-borne device 100 and the interaction surface 210 within the VR environment (e.g., representing the user-borne device 100 being operated on the interaction surface 210 within the VR environment). Based on an actuation of the at least one contact manipulation feature 170 (e.g., by a user), the system 10 may be configured to detect the transition and to determine the contact event. Based on the determined contact event, the system 10 may adjust the location (including the position and/or orientation) of the interaction surface within the digital (or virtual) environment. In examples, a distance and/or orientation of the "virtual" interaction surface may thereby be adjusted relative to the XR headset worn by the user.

### Method

According to a third aspect of the present disclosure, a method 600 for determining a manipulation of a user-borne device 100 is provided. Methods for determining the location of a user-borne device with a plurality of magnetometers, and the manipulation of a user-borne device 100 within a sensing volume, associated algorithms are already known in the prior art, for example in US 2013/249784 A1, US 2020/116524 A1 or US 2015/057969 A1.

Basically, the method 600 may comprise determining a user-borne device location within the sensing volume M created by the plurality of magnetometers 300 and based on the obtained magnetic field measurements. The method 600 may comprise defining the reference coordinate system XYZ as described above. Determining a user-borne device location may comprise determining an absolute magnetic object location indicative of an absolute magnetic object position and/or an absolute magnetic object orientation of the magnetic object 110 relative to the reference coordinate system XYZ. More specifically, the absolute magnetic object location may be determined based on the obtained magnetic field measurements. The absolute magnetic object location may comprise an absolute magnetic object position and/or an absolute magnetic object orientation relative to the reference coordinate system XYZ. The absolute magnetic object location may be determined based on an implementation of a mathematical model associating each measurement of a magnetometer of the plurality of magnetometers 300 with a location of the magnetic object 110 in the reference coordinate system XYZ. Each magnetometer of the plurality of magnetometers 300 may be a vector magnetometer and may be configured to measure the magnetic field in one, two or three dimensions. In an embodiment, a coulombian model may be implemented, which may allow a modeling of complex magnetizations of the magnetic object 110. Determining a user-borne device location may further comprise determining a relative magnetic object location indicative of a relative magnetic object position and/or a relative magnetic object orientation of the magnetic object relative to the user-borne device 100, more specifically to a device coordinate system as described above. The relative magnetic object location may comprise a relative magnetic object position and/or a relative magnetic object orientation relative to the device coordinate system. Determining a relative magnetic object location may be based on the absolute magnetic object location as described above and a set of geometric parameters. The set of geometric parameters may comprise predefined geometric parameters indicative of a geometric position and a geometric orientation of the magnetic object 100 relative to the user-borne device 100, more specifically relative to the housing 101 in the first state (i.e., the first location and initial location of the magnetic object) In other words, based on the determined absolute location of the magnetic object 110 and the knowledge of the arrangement of the magnetic object 110 within the user-borne device 100 (more specifically relative to the device coordinate system), the user-borne device location may be known. In embodiments, the method 600 may further comprise applying a filter for filtering the determined user-borne device location. Magnetic and electronic noise, as well as environmental variations may lead to non-smooth location determinations over time. Based on the filtering, a smooth location trajectory of the user-borne device 100 relative to the reference coordinate system XYZ and/or to interaction surface 210 may be achieved. The filter may be a low-pass filter or a Kalman filter, more specifically an extended Kalman filter or an unscented Kalman filter. The method 600 may further comprise initializing the plurality of magnetometers 300 and the user-borne device 100, more specifically when a user U starts a user operation. In embodiments, the user-borne device 100 and/or the magnetic object 110 may be tracked over a time period comprising multiple time samples. At each time sample, the method 600 may comprise determining the user-borne device location. The method may further comprise storing the determined and/or detected features for each time sample.

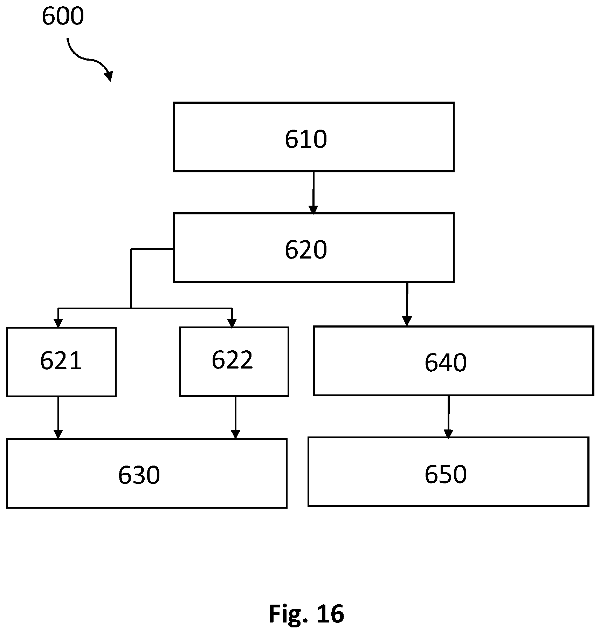

Fig. 16 schematically illustrates a process flow diagram of the method 600 according to the present disclosure. The method 600 comprises obtaining magnetic field measurements 610 associated with a magnetic field created by a magnetic object 110 coupled to a housing 101 of a user-borne device 100 according to the first aspect of the present disclosure and measured with a plurality of magnetometers 300. In other words, the method 600 may comprise obtaining measurements of a magnetic field created or generated by the magnetic object 110 and measured with the plurality of magnetometers 300. Furthermore, the method 600 comprises detecting a transition 620 of the magnetic object 110 from a first state to a second state and determining a contact event 630 of the user-borne device 100 with the interaction surface 210 based on the detected transition. Additionally or alternatively, the method 600 may comprise determining a pressure event of the user-borne device 600 based on the detected transition. In embodiments, detecting a transition 620 may comprise detecting a location change 621 and/or detecting a magnetic field change 622 of the magnetic object 110, more specifically outside the housing 101. The above-described effects and advantages may apply analogously to the method 600.

The method 600 may comprise determining an interaction surface location, wherein the interaction surface location may be indicative of an interaction surface position, an interaction surface orientation and/or an interaction surface distance relative to the reference coordinate system XYZ, more specifically to the magnetometer plane 310. Determining the interaction surface location may be based on detecting the transition and determining the contact event as described above. Determining the interaction surface location may comprise deriving a geometric position and/or a geometric orientation of the interaction surface 210 relative to the reference coordinate system XYZ and the user-borne device 100 based on the determined contact event. More specifically, in case the user-borne device 100 comprises a contact surface 130 (e.g., the computer mouse embodiment), the method 600 may comprise deriving a plane of the interaction surface 210 based on the determined contact event (which indicates that the device contact surface or point 130 lies on the interaction surface 210). In some embodiments wherein the user-borne device 100 comprises a device contact point (e.g., Figs. 9A and 9B), the method 600 may determine multiple contact events from which the method 600 may derive multiple device contact points on the interaction surface 210. The method may comprise prompting a user U via the user interface to actuate the at least one contact manipulation feature 170 at multiple interaction surface locations of the interaction surface 210 which are distanced to each other. The multiple interaction surface locations may be stored and the method may comprise deriving a set of geometric parameters describing the interaction surface 210 with high accuracy and reliability.

The method 600 may comprise determining the user-borne device location relative to the interaction surface 210 based on the interaction surface location. The method 600 may further comprise determining a contact location of the user-borne device 100 relative to the interaction surface 210, more specifically based on the determined user-borne device location and the determined interaction surface location. This can be provided with high accuracy and reliability since the interaction surface location and in turn the contact location can be derived from the determined contact event.

Detecting a location change 621 may comprise detecting a movement of the magnetic object 110 relative to the housing 101 from a first location to a second location, more specifically wherein the movement may comprise a translation and/or rotation of the magnetic object 110. As described above, the movement may comprise a movement trajectory, a movement velocity range, and/or a movement time range. Determining a contact event 630 may comprise comparing the movement of the magnetic object 110 with a predefined movement. The method 600 may communicate with a data base storing predefined movements, e.g., including a predefined movement trajectory, a predefined movement velocity range, and/or a predefined movement time range. Determining a contact event 630 may comprise determining whether the movement of the magnetic object 110 matches the predefined movement, and in response to determining that the movement of the magnetic object 110 matches the predefined movement, determining the contact event 630 , wherein the contact event may be indicative that the user-borne device 100 is in contact with the interaction surface 210. Additionally or alternatively, determining a pressure event may comprise comparing the movement of the magnetic object 110 with the predefined movement. Determining a pressure event may comprise determining whether the movement of the magnetic object 110 matches the predefined movement, and in response to determining that the movement of the magnetic object 110 matches the predefined movement, determining the pressure event, wherein the pressure event may be indicative of an amount of pressure (e.g., over time) applied to the at least one contact manipulation feature 170.

Detecting a magnetic field change 622 may comprise determining a change of the magnetic field created by the magnetic object 110 outside the user-borne device 100, more specifically outside the housing 101, from a first magnetic field in the first state to a second magnetic field in the second state, wherein the second magnetic field may be different from the first magnetic field. As described above, the magnetic field may comprise a magnetic field strength and/or a magnetic field form. Determining the change (or transition) of the magnetic field may comprise detecting a change of the magnetic field strength and/or a change of the magnetic field form. The first magnetic field of the magnetic object 110 may comprise a first magnetic field strength and/or a first magnetic field form in the first state, and the second magnetic field of the magnetic object 110 may comprise a second magnetic field strength and/or a second magnetic field form in the second state. Determining a transition of the magnetic field created by the magnetic object 110 from the first magnetic field in the first state to the second magnetic field in the second state may comprise determining that the second magnetic field strength is larger or smaller than the first magnetic field strength, and/or determining that the second magnetic field form is different from the first magnetic field form.

In some embodiments, determining a contact event 630 may comprise setting a threshold for the change of the magnetic field strength and/or the change of the magnetic field form. Furthermore, determining a contact event 630 may comprise rejecting magnetic field measurements associated with a change of the magnetic field strength and/or the change of the magnetic field form being equal to or less than the set threshold for the change of the magnetic field strength and/or the change of the magnetic field form, and/or accepting magnetic field measurements associated with a change of the magnetic field strength and/or the change of the magnetic field form being larger than the set threshold for the change of the magnetic field strength and/or the change of the magnetic field form. Thereby, small changes of a magnetic field that might occur due to the interaction of the magnetic object 110 with respect to e.g., another magnetic object (e.g., click and scroll movements) can be differentiated from a contact event. This may allow for a more precise and reliable determination of a contact event., e.g., which can occur when the magnetic object transitions from the covered location to the exposed location. In some embodiments, determining a contact event 630 may comprise, in response to detecting the change of the magnetic field strength and/or the change of the magnetic field form, determining the contact event, wherein the contact event may be indicative that the user-borne device 100 is in contact with the interaction surface 210.

In some embodiments, the method 600 may further comprise detecting a translation and/or rotation 640 of the magnetic object 110 about or relative to a first rotation axis 112 and at least one second rotation axis 114, 116 based on the obtained magnetic field measurements, and in response to a detected translation and/or rotation, determining at least one trigger event 650 based on the detected translation and/or rotation. In some embodiments, method 600 may further comprise determining the at least one trigger event only in response to detecting the contact event. In embodiments, determining at least one trigger event 650 may comprise determining a manipulation of the user-borne device 100, more specifically a control of the user-borne device 100, within the sensing volume M created by the plurality of magnetometers 300 based on the detected translation and/or rotation, and associating the manipulation with the at least one trigger event. Determining the at least one trigger event 650 may comprise determining a click event based on detecting a transition of the magnetic object 110, 110a from the first state to the second state or based on a detected translation and/or rotation of the at least one second magnetic object 110 relative to the housing 101 due to an actuation of the at least one click manipulation feature 150, and/or determining a scroll event based on detecting a transition of the magnetic object 110, 110a from the first state to the second state or based on a detected translation and/or rotation of the at least one second magnetic object 110 relative to the housing 101 due to an actuation of the at least one scroll manipulation feature 140.

The method 600 may further comprise representing the user-borne device 100 and/or the magnetic object 110 on the output device 510. More specifically, representing the user-borne device 100 on an output device 510 may comprise reproducing the user-borne device 100 as a virtual object on the output device 510. Representing the user-borne device 100 may further comprise reproducing a movement of the user-borne device 100 and/or the magnetic object 110 within the sensing volume M and/or relative to the interaction surface 210 as a movement of the virtual object on the output device 510. The movement of the user-borne device 100 within the sensing volume M may be caused by a manipulation of the user-borne device 100 during a user operation (i.e., by a user manipulating the location of the user-borne device 100 and/or the magnetic object 110). In other words, the movement of the user-borne location may be determined and reproduced as a movement of the virtual object on the output device 510. The visual reproduction may be a motion of a cursor on the output device 510. In embodiments, the visual reproduction may not be identical to the design of the user-borne device 100 but may be any icon (e.g., an arrow, a picture).

The method 600 as described above, may be a computer-implemented method. According to an aspect of the present disclosure, a computer system may be configured to execute the computer-implemented method 600 as described above. According to another aspect of the present disclosure a computer program may be configured to execute the computer-implemented method 600 as described above. Furthermore, a computer-readable medium or signal storing the computer program may be provided.

The above-described computer-implemented method 600 can comprise or be executable via a computer or a network of computers, the computer or network of computers comprising at least one processing unit (e.g., a processor) and at least one data storage (i.e., memory). The described procedural logic may be held in the form of executable code in at least one data storage and executed by the at least one processing unit. The systems and subsystems may send data to the at least one processing unit and, in examples, they may also receive instructions from the at least one processing unit. The processing unit may thereby direct user-initiated and/or automatically generated queries to the system 10. The system 10 is not limited to a particular hardware environment. Thus, distributed devices coupled via a network may perform the techniques described herein. The disclosure also includes electrical signals and computer-readable media defining instructions that, when executed by a processing unit, implement the techniques described herein. As described above, the system 10 may comprise at least one database. Alternatively, or in addition, the system 10 may access a database in a cloud (via a communication interface). The system 10 may comprise a (at least one) communication interface to couple to plurality of magnetometers, the processing unit and/or the database. The communication interface may comprise one or more of a network, internet, a local area network, a wireless local area network, a broadband cellular network, and/or a wired network. In examples, the system 10 may couple to one or more features via a server hosted in a cloud.

In some embodiments, more than one user-borne devices 100 may be provided and operated (e.g., manipulated by a user U) within the sensing volume M created by the plurality of magnetometers 300. Although the method 600 and the system 10 according to the present disclosure have been described for one user-borne device 100, the features as described above may also be applicable to every additional or other user-borne device 100 operated within the sensing volume M.

### REFERENCE NUMERALS

- X: first reference axis
- Y: second reference axis
- Z: vertical reference axis
- x_{d}: first device axis
- y_{d}: second device axis
- z_{d}: vertical device axis
- xₛ: first surface axis
- yₛ: second surface axis
- zₛ: vertical surface axis
- M: sensing volume
- 1: protruding distance
- l₁: first protruding distance
- l₂: second protruding distance
- z₁: first distance
- z₂: second distance
- α₁: first rotation angle
- α₂: second rotation angle
- β₁: first gear wheel rotation angle
- β₂: second gear wheel rotation angle
- µ: rotation angle
- γ₁: first inclination angle
- γ₂: second inclination angle
- γ₃: third inclination angle
- 10: system
- 100: user-borne device
- 101: housing
- 110: magnetic object
- 110a: first magnetic object
- 110b: second magnetic object
- 112: first rotation axis
- 114: second rotation axis
- 115: magnetic field
- 116: third rotation axis
- 118: transmission rotation axis
- 120: magnetic moment vector
- 130: contact surface or point
- 140: scroll manipulation feature
- 150: click manipulation feature
- 160: transmission device
- 160a: lever transmission
- 160b: gear transmission
- 161: biasing mechanism
- 162: lever member
- 162a: first lever member
- 162b: second lever member
- 163: gear wheel
- 164: magnetic field modification element
- 170: contact manipulation feature
- 171: actuation element
- 172: engagement features
- 180: first rotation
- 190: second rotation
- 200: interaction support
- 210: interaction surface
- 230: interaction support surface
- 300: plurality of magnetometers
- 310: magnetometer plane
- 320: magnetometer body
- 400: processing unit
- 500: electronics device
- 510: output device
- U: user
- S_{k,l}: magnetometer

## Claims

1. A user-borne device (100) operable on an interaction surface (210), the user-borne device (100) comprising:
a housing (101),
a magnetic object (110) coupled to the housing (101), and
at least one contact manipulation feature (170) movably coupled to the housing (101),
**characterized in that** the at least one contact manipulation feature (170) is configured to interact with the magnetic object (110) such that an actuation of the at least one contact manipulation feature (170) causes a transition of the magnetic object (110) from a first state to a second state,
wherein the first state is indicative of the user-borne device (100) being distanced to the interaction surface (210) and the second state is indicative of the user-borne device (100) being in contact with the interaction surface (210), and
wherein the transition from the first state to the second state is indicative of a contact event of the user-borne device (100) with the interaction surface (210).

2. The user-borne device (100) according to claim 1, wherein the user-borne device (100) comprises a transmission device (160) operatively coupled to the at least one contact manipulation feature (170) and configured to interact with the magnetic object (110) such that the magnetic object (110) is transitioned from the first state to the second state when the at least one manipulation feature (170) is actuated.

3. The user-borne device (100) according to claim 1 or claim 2, wherein the transition comprises a location change of the magnetic object (110) relative to the housing (101), more specifically wherein the location of the magnetic object (110) comprises a position and/or an orientation of the magnetic object (110) relative to the housing (101).

4. The user-borne device (100) according to any one of the preceding claims, wherein the at least one contact manipulation feature (170) is mechanically coupled to the magnetic object (110), and wherein the magnetic object (110) is arranged rotatable and/or translatable with respect to the housing (101).

5. The user-borne device (100) according to any one of claims 2 to 4, wherein the magnetic object (110) is operatively coupled to the transmission device (160), more specifically wherein the at least one contact manipulation feature (170) is mechanically coupled to the magnetic object (110) via the transmission device (160).

6. The user-borne device (100) according to any one of the preceding claims, wherein the user-borne device (100) comprises a magnetic field modification element (164) configured to magnetically interact with the magnetic object (110), more specifically with the magnetic field (115) created by the magnetic object (110).

7. The user-borne device (100) according to claim 6, wherein the magnetic object (110) is operatively coupled to the at least one contact manipulation feature (170) and configured to change its location with respect to the modification element (164) when the at least one manipulation feature (170) is actuated.

8. The user-borne device (100) according to claim 6, when dependent on any one of claims 1 to 3, wherein the modification element (164) is operatively coupled to the at least one contact manipulation feature (170) and configured to change its location with respect to the magnetic object (110) when the at least one manipulation feature (170) is actuated.

9. The user-borne device (100) according to any one of the preceding embodiments, wherein the housing (101) comprises a device contact surface (130), and wherein the housing (101) comprises an opening (102) in the device contact surface (130) through which the at least one contact manipulation feature (170) is movable, more specifically wherein in the first state, the at least one manipulation feature (170) at least partially protrudes through the opening (102) and out of the housing (101), and particularly wherein the at least one manipulation feature (170) is configured to rotate and/or translate into the housing (101) when contacting the interaction surface (210).

10. The user-borne device (100) according to any one of the preceding claims, wherein the user-borne device (100) comprises at least one click manipulation feature (150) and/or at least one scroll manipulation feature (140), wherein the at least one click manipulation feature (150) and/or the at least one scroll manipulation feature (140) are movably coupled to the housing (101) and actuatable by a user (U).

11. The user-borne device (100) according to claim 10, wherein the at least one click manipulation feature (150), the at least one scroll manipulation feature (140) and/or the at least one contact manipulation feature (170) are configured to interact with the magnetic object (110) such that an actuation of the at least one click manipulation feature (150), the at least one scroll manipulation feature (140) and/or the at least one contact manipulation feature (170) cause the transition of the magnetic object (110) from the first state to the second state, more specifically wherein the magnetic object (110) is operatively coupled to the at least one click manipulation feature (150) and/or to the at least one scroll manipulation feature (140) such that an actuation of the at least one click manipulation feature (150) and/or at least one scroll manipulation feature (140) causes a rotation and/or translation of the magnetic object (110) with respect to the housing (101).

12. The user-borne device (100) according to any one of the preceding claims, wherein the magnetic object (110) is a first magnetic object (110a), and wherein the user-borne device (100) comprises at least one second magnetic object (110b), wherein the first magnetic object (110a) and the at least one second magnetic object (110b) are arranged distanced to each other.

13. A system (10) for determining a manipulation of a user-borne device (100), comprising:
a user-borne device (100) according to any one of the preceding claims, and
a plurality of magnetometers (300) configured to create a sensing volume and configured to measure a magnetic field created by the magnetic object (110),
wherein the system (10) is configured to detect a transition of the magnetic object (110) from a first state to a second state, and
wherein the system (10) is configured to determine a contact event of the user-borne device (100) with the interaction surface (210) based on the detected transition.

14. A computer-implemented method (600) for determining a manipulation of a user-borne device (100), comprising:
obtaining magnetic field measurements (610) associated with a magnetic field (115) created by a magnetic object (110) coupled to a housing (101) of a user-borne device (100) according to any one of the preceding claims 1 to 12 and measured with a plurality of magnetometers (300),
detecting a transition (620) of the magnetic object (110) from a first state to a second state, and
determining a contact event (630) of the user-borne device (100) with the interaction surface (210) based on the detected transition.

15. A computer program configured to execute the computer-implemented method (600) according to claim 14.

16. A computer-readable medium storing the computer program of claim 15.

## Patentansprüche

1. Benutzergetragene Vorrichtung (100), die auf einer Interaktionsoberfläche (210) betreibbar ist, wobei die benutzergetragene Vorrichtung (100) umfasst:
ein Gehäuse (101),
ein magnetisches Objekt (110), das mit dem Gehäuse (101) gekoppelt ist, und
mindestens ein Kontaktmanipulationsmerkmal (170), das beweglich mit dem Gehäuse (101) gekoppelt ist,
**dadurch gekennzeichnet, dass** das mindestens eine Kontaktmanipulationsmerkmal (170) konfiguriert ist, um mit dem magnetischen Objekt (110) derart zu interagieren, dass eine Betätigung des mindestens einen Kontaktmanipulationsmerkmals (170) einen Übergang des magnetischen Objekts (110) von einem ersten Zustand in einen zweiten Zustand bewirkt,
wobei der erste Zustand angibt, dass die benutzergetragene Vorrichtung (100) von der Interaktionsoberfläche (210) beabstandet ist, und der zweite Zustand angibt, dass die benutzergetragene Vorrichtung (100) in Kontakt mit der Interaktionsoberfläche (210) ist, und
wobei der Übergang vom ersten Zustand in den zweiten Zustand eine Angabe über ein Kontaktereignis der benutzergetragenen Vorrichtung (100) mit der Interaktionsoberfläche (210) ist.

2. Benutzergetragene Vorrichtung (100) nach Anspruch 1, wobei die benutzergetragene Vorrichtung (100) eine Übertragungsvorrichtung (160) umfasst, die betriebsmäßig mit dem mindestens einen Kontaktmanipulationsmerkmal (170) gekoppelt und konfiguriert ist, um mit dem magnetischen Objekt (110) derart zu interagieren, dass das magnetische Objekt (110) von dem ersten Zustand in den zweiten Zustand übergeht, wenn das mindestens eine Manipulationsmerkmal (170) betätigt wird.

3. Benutzergetragene Vorrichtung (100) nach Anspruch 1 oder 2, wobei der Übergang eine Ortsänderung des magnetischen Objekts (110) relativ zum Gehäuse (101) umfasst, insbesondere wobei der Ort des magnetischen Objekts (110) eine Position und/oder eine Ausrichtung des magnetischen Objekts (110) relativ zum Gehäuse (101) umfasst.

4. Benutzergetragene Vorrichtung (100) nach einem der vorstehenden Ansprüche, wobei das mindestens eine Kontaktmanipulationsmerkmal (170) mechanisch mit dem magnetischen Objekt (110) gekoppelt ist, und wobei das magnetische Objekt (110) drehbar und/oder translatorisch in Bezug auf das Gehäuse (101) angeordnet ist.

5. Benutzergetragene Vorrichtung (100) nach einem der Ansprüche 2 bis 4, wobei das magnetische Objekt (110) operativ mit der Übertragungsvorrichtung (160) gekoppelt ist, insbesondere wobei das mindestens eine Kontaktmanipulationsmerkmal (170) über die Übertragungsvorrichtung (160) mechanisch mit dem magnetischen Objekt (110) gekoppelt ist.

6. Benutzergetragene Vorrichtung (100) nach einem der vorstehenden Ansprüche, wobei die benutzergetragene Vorrichtung (100) ein Magnetfeldmodifikationselement (164) umfasst, das konfiguriert ist, um magnetisch mit dem magnetischen Objekt (110) zu interagieren, insbesondere mit dem Magnetfeld (115), das von dem magnetischen Objekt (110) erzeugt wird.

7. Benutzergetragene Vorrichtung (100) nach Anspruch 6, wobei das magnetische Objekt (110) operativ mit dem mindestens einen Kontaktmanipulationsmerkmal (170) gekoppelt und konfiguriert ist, um seinen Ort in Bezug auf das Modifikationselement (164) zu ändern, wenn das mindestens eine Manipulationsmerkmal (170) betätigt wird.

8. Benutzergetragene Vorrichtung (100) nach Anspruch 6, in Abhängigkeit von einem der Ansprüche 1 bis 3, wobei das Modifikationselement (164) operativ mit dem mindestens einen Kontaktmanipulationsmerkmal (170) gekoppelt und konfiguriert ist, um seinen Ort in Bezug auf das magnetische Objekt (110) zu ändern, wenn das mindestens eine Manipulationsmerkmal (170) betätigt wird.

9. Benutzergetragene Vorrichtung (100) nach einer der vorstehenden Ausführungsformen, wobei das Gehäuse (101) eine Vorrichtungskontaktoberfläche (130) umfasst, und wobei das Gehäuse (101) eine Öffnung (102) in der Vorrichtungskontaktoberfläche (130) umfasst, durch die das mindestens eine Kontaktmanipulationsmerkmal (170) bewegt werden kann, wobei insbesondere im ersten Zustand das mindestens eine Manipulationsmerkmal (170) mindestens teilweise durch die Öffnung (102) und aus dem Gehäuse (101) herausragt, und wobei insbesondere das mindestens eine Manipulationsmerkmal (170) konfiguriert ist, um sich in das Gehäuse (101) zu drehen und/oder zu übersetzen, wenn es die Interaktionsoberfläche (210) berührt.

10. Benutzergetragene Vorrichtung (100) nach einem der vorstehenden Ansprüche, wobei die benutzergetragene Vorrichtung (100) mindestens ein Klickmanipulationsmerkmal (150) und/oder mindestens ein Scrollmanipulationsmerkmal (140) umfasst, wobei das mindestens eine Klickmanipulationsmerkmal (150) und/oder das mindestens eine Scrollmanipulationsmerkmal (140) beweglich mit dem Gehäuse (101) gekoppelt und durch einen Benutzer (U) betätigbar ist.

11. Benutzergetragene Vorrichtung (100) nach Anspruch 10, wobei das mindestens eine Klickmanipulationsmerkmal (150), das mindestens eine Scrollmanipulationsmerkmal (140) und/oder das mindestens eine Kontaktmanipulationsmerkmal (170) konfiguriert sind, um mit dem magnetischen Objekt (110) derart zu interagieren, dass eine Betätigung des mindestens einen Klickmanipulationsmerkmals (150), des mindestens einen Scrollmanipulationsmerkmals (140) und/oder des mindestens einen Kontaktmanipulationsmerkmals (170) den Übergang des magnetischen Objekts (110) von dem ersten Zustand in den zweiten Zustand bewirkt, wobei insbesondere das magnetische Objekt (110) operativ mit dem mindestens einen Klickmanipulationsmerkmal (150) und/oder dem mindestens einen Scrollmanipulationsmerkmal (140) gekoppelt ist, sodass eine Betätigung des mindestens einen Klickmanipulationsmerkmals (150) und/oder des mindestens einen Scrollmanipulationsmerkmals (140) eine Drehung und/oder Translation des magnetischen Objekts (110) in Bezug auf das Gehäuse (101) bewirkt.

12. Benutzergetragene Vorrichtung (100) nach einem der vorstehenden Ansprüche, wobei das magnetische Objekt (110) ein erstes magnetisches Objekt (110a) ist, und wobei die benutzergetragene Vorrichtung (100) mindestens ein zweites magnetisches Objekt (110b) umfasst, wobei das erste magnetische Objekt (110a) und das mindestens eine zweite magnetische Objekt (110b) beabstandet zueinander angeordnet sind.

13. System (10) zum Bestimmen einer Manipulation einer benutzergetragenen Vorrichtung (100), umfassend:
eine benutzergetragene Vorrichtung (100) nach einem der vorstehenden Ansprüche, und
eine Vielzahl von Magnetometern (300), die konfiguriert sind, um ein Erfassungsvolumen zu erzeugen, und die konfiguriert sind, um ein Magnetfeld zu messen, das durch das magnetische Objekt (110) erzeugt wird,
wobei das System (10) konfiguriert ist, um einen Übergang des magnetischen Objekts (110) von einem ersten Zustand zu einem zweiten Zustand zu erfassen, und
wobei das System (10) konfiguriert ist, um ein Kontaktereignis der benutzergetragenen Vorrichtung (100) mit der Interaktionsoberfläche (210) basierend auf dem erkannten Übergang zu bestimmen.

14. Computerimplementiertes Verfahren (600) zum Bestimmen einer Manipulation einer benutzergetragenen Vorrichtung (100), umfassend:
Erhalten von Magnetfeldmessungen (610), die mit einem Magnetfeld (115) verbunden sind, das durch ein magnetisches Objekt (110) erzeugt wird, das mit einem Gehäuse (101) einer benutzergetragenen Vorrichtung (100) nach einem der vorstehenden Ansprüche 1 bis 12 gekoppelt ist und mit einer Vielzahl von Magnetometern (300) gemessen wird,
Erfassen eines Übergangs (620) des magnetischen Objekts (110) von einem ersten Zustand in einen zweiten Zustand, und
Bestimmen eines Kontaktereignisses (630) der benutzergetragenen Vorrichtung (100) mit der Interaktionsoberfläche (210) basierend auf dem erfassten Übergang.

15. Computerprogramm, das konfiguriert ist, um das computerimplementierte Verfahren (600) nach Anspruch 14 auszuführen.

16. Computerlesbares Medium, das das Computerprogramm nach Anspruch 15 speichert.

## Revendications

1. Dispositif (100) porté par un utilisateur, pouvant fonctionner sur une surface d'interaction (210), le dispositif (100) porté par un utilisateur comprenant :
un boîtier (101),
un objet magnétique (110) accouplé au boîtier (101), et
au moins une caractéristique de manipulation de contact (170) accouplée de manière mobile au boîtier (101),
**caractérisé en ce que** l'au moins une caractéristique de manipulation de contact (170) est configurée pour interagir avec l'objet magnétique (110) de telle sorte qu'un actionnement de l'au moins une caractéristique de manipulation de contact (170) provoque une transition de l'objet magnétique (110) d'un premier état à un second état,
dans lequel le premier état indique que le dispositif (100) porté par un utilisateur est éloigné de la surface d'interaction (210) et le second état indique que le dispositif (100) porté par un utilisateur est en contact avec la surface d'interaction (210), et
dans lequel la transition du premier état au second état indique un événement de contact du dispositif (100) porté par un utilisateur avec la surface d'interaction (210).

2. Dispositif (100) porté par un utilisateur selon la revendication 1, dans lequel le dispositif (100) porté par un utilisateur comprend un dispositif de transmission (160) couplé de manière fonctionnelle à l'au moins une caractéristique de manipulation de contact (170) et configuré pour interagir avec l'objet magnétique (110) de telle sorte que l'objet magnétique (110) passe du premier état au second état lorsque l'au moins une caractéristique de manipulation (170) est actionnée.

3. Dispositif (100) porté par un utilisateur selon la revendication 1 ou la revendication 2, dans lequel la transition comprend un changement d'emplacement de l'objet magnétique (110) par rapport au boîtier (101), plus précisément dans lequel l'emplacement de l'objet magnétique (110) comprend une position et/ou une orientation de l'objet magnétique (110) par rapport au boîtier (101).

4. Dispositif (100) porté par un utilisateur selon l'une quelconque des revendications précédentes, dans lequel l'au moins une caractéristique de manipulation de contact (170) est accouplée mécaniquement à l'objet magnétique (110), et dans lequel l'objet magnétique (110) est agencé de manière à pouvoir tourner et/ou effectuer une translation par rapport au boîtier (101).

5. Dispositif (100) porté par un utilisateur selon l'une quelconque des revendications 2 à 4, dans lequel l'objet magnétique (110) est couplé de manière opérationnelle au dispositif de transmission (160), plus précisément dans lequel l'au moins une caractéristique de manipulation de contact (170) est accouplée mécaniquement à l'objet magnétique (110) par l'intermédiaire du dispositif de transmission (160).

6. Dispositif (100) porté par un utilisateur selon l'une quelconque des revendications précédentes, dans lequel le dispositif (100) porté par un utilisateur comprend un élément de modification de champ magnétique (164) configuré pour interagir magnétiquement avec l'objet magnétique (110), plus spécifiquement avec le champ magnétique (115) créé par l'objet magnétique (110).

7. Dispositif (100) porté par un utilisateur selon la revendication 6, dans lequel l'objet magnétique (110) est couplé de manière opérationnelle à l'au moins une caractéristique de manipulation de contact (170) et configuré pour changer sa localisation par rapport à l'élément de modification (164) lorsque l'au moins une caractéristique de manipulation (170) est actionnée.

8. Dispositif (100) porté par un utilisateur selon la revendication 6, lorsqu'elle dépend de l'une quelconque des revendications 1 à 3, dans lequel l'élément de modification (164) est couplé de manière opérationnelle à l'au moins une caractéristique de manipulation de contact (170) et configuré pour changer son emplacement par rapport à l'objet magnétique (110) lorsque l'au moins une caractéristique de manipulation (170) est actionnée.

9. Dispositif (100) porté par un utilisateur selon l'un quelconque des modes de réalisation précédents, dans lequel le boîtier (101) comprend une surface de contact de dispositif (130), et dans lequel le boîtier (101) comprend une ouverture (102) dans la surface de contact de dispositif (130) à travers laquelle l'au moins une caractéristique de manipulation de contact (170) est mobile, plus précisément dans lequel dans le premier état, l'au moins une caractéristique de manipulation (170) fait saillie au moins partiellement à travers l'ouverture (102) et hors du boîtier (101), et en particulier dans lequel l'au moins une caractéristique de manipulation (170) est conçue pour tourner et/ou effectuer translation dans le boîtier (101) lorsqu'elle entre en contact avec la surface d'interaction (210).

10. Dispositif (100) porté par un utilisateur selon l'une quelconque des revendications précédentes, dans lequel le dispositif (100) porté par un utilisateur comprend au moins une caractéristique de manipulation de clic (150) et/ou au moins une caractéristique de manipulation de défilement (140), dans lequel l'au moins une caractéristique de manipulation de clic (150) et/ou l'au moins une caractéristique de manipulation de défilement (140) sont accouplées de manière mobile au boîtier (101) et actionnables par un utilisateur (U).

11. Dispositif (100) porté par un utilisateur selon la revendication 10, dans lequel l'au moins une caractéristique de manipulation de clic (150), l'au moins une caractéristique de manipulation de défilement (140) et/ou l'au moins une caractéristique de manipulation de contact (170) sont configurées pour interagir avec l'objet magnétique (110) de telle sorte qu'un actionnement de l'au moins une caractéristique de manipulation de clic (150), de l'au moins une caractéristique de manipulation de défilement (140) et/ou de l'au moins une caractéristique de manipulation de contact (170) provoque la transition de l'objet magnétique (110) du premier état au second état, plus précisément dans lequel l'objet magnétique (110) est couplé de manière opérationnelle à l'au moins une caractéristique de manipulation de clic (150) et/ou à l'au moins une caractéristique de manipulation de défilement (140) de telle sorte qu'un actionnement de l'au moins une caractéristique de manipulation de clic (150) et/ou de l'au moins une caractéristique de manipulation de défilement (140) provoque une rotation et/ou une translation de l'objet magnétique (110) par rapport au boîtier (101).

12. Dispositif (100) porté par un utilisateur selon l'une quelconque des revendications précédentes, dans lequel l'objet magnétique (110) est un premier objet magnétique (110a), et dans lequel le dispositif (100) porté par un utilisateur comprend au moins un second objet magnétique (110b), dans lequel le premier objet magnétique (110a) et l'au moins un second objet magnétique (110b) sont agencés à distance l'un de l'autre.

13. Système (10) permettant de déterminer une manipulation d'un dispositif (100) porté par un utilisateur, comprenant :
un dispositif (100) porté par un utilisateur selon l'une quelconque des revendications précédentes, et
une pluralité de magnétomètres (300) configurés pour créer un volume de détection et configurés pour mesurer un champ magnétique associé à l'au moins un objet magnétique (110),
dans lequel le système (10) est configuré pour détecter une transition de l'objet magnétique (110) d'un premier état à un second état, et
dans lequel le système (10) est configuré pour déterminer un événement de contact du dispositif (100) porté par un utilisateur avec la surface d'interaction (210) sur la base de la transition détectée.

14. Procédé mis en œuvre par ordinateur (600) permettant de déterminer une manipulation d'un dispositif (100) porté par un utilisateur, comprenant :
l'obtention de mesures de champ magnétique (610) associées à un champ magnétique (115) créé par un objet magnétique (110) accouplé à un boîtier (101) d'un dispositif (100) porté par un utilisateur selon l'une quelconque des revendications 1 à 12 précédentes et mesuré avec une pluralité de magnétomètres (300),
la détection d'une transition (620) de l'objet magnétique (110) d'un premier état à un second état, et
la détermination d'un événement de contact (630) du dispositif (100) porté par un utilisateur avec la surface d'interaction (210) sur la base de la transition détectée.

15. Programme informatique configuré pour exécuter le procédé mis en œuvre par ordinateur (600) selon la revendication 14.

16. Support lisible par ordinateur stockant le programme informatique selon la r evendication 15.
